# EUROPEAN PATENT SPECIFICATION

(11) **EP 1 099 119 B1**
(45) Date of publication and mention of the grant of the patent: **20.05.2009**
(21) Application number: 99934909.5
(22) Date of filing: 21.07.1999
(51) Int. Cl.: G01R 31/36

(54) **SIGNALLING SYSTEM**
SIGNALISIERUNGSSYSTEM
SYSTEME DE SIGNALISATION

(30) Priority: 21.07.1998 GB 9815899; 26.11.1998 GB 9825954; 27.11.1998 GB 9826141
(43) Date of publication of application: 16.05.2001
(60) Divisional application: 08162301.9
(73) Proprietor: Metrixx Limited, Aberdeen AB10 1FW (GB)
(72) Inventor: PUCHIANU, Silviu, The Innovation Centre, Bridge of Don, Aberdeen AB 23 8GX (GB)
(74) Representative: Bird, Ariane
(86) International application number: PCT/GB1999/002356
(87) International publication number: WO 2000/005596

(56) References cited:
- US-A- 4 217 645
- US-A- 4 697 134

## Description

The present invention relates to a signalling system. The invention is applicable for use in a system for monitoring and/or controlling the cells of an industrial battery.

Industrial batteries comprise a number of rechargeable battery cells which can be electrically connected in various series and series-parallel combinations to provide a rechargeable battery having a desired output voltage. To recharge the battery, a current is passed through the cells in the opposite direction of current flow when the cells are working. There are many different types of battery cells available, but those most commonly used in industrial applications are lead acid battery cells, each of which provides 2 volts, and nickel-cadmium (Nicad) battery cells, each of which provides 1.2 volts.

The batteries are usually used as a back-up power supply for important systems in large industrial plants, such as off-shore oil rigs, power stations and the like. Since the batteries are provided as back-up in the event of a fault with the main generators, they must be constantly monitored and maintained so that they can provide power to the important systems for a preset minimum amount of time.

Many battery monitoring systems have been proposed which monitor the battery as a whole and provide an indication of the battery voltage. However, only a few systems have been proposed which can also monitor the individual cells which make up the battery. These systems use a number of monitoring devices, some of which are powered by the battery cell or cells which they monitor and send status information indicative of the cell voltage back to a central battery monitoring system which monitors the battery as a whole. Such a system is described in EP065745.

However, since the cells are connected in series and since each cell monitoring device is powered by the cell which it is monitoring, the ground or reference voltage of each cell monitoring device is different. For example, in an industrial battery which has sixty lead acid cells connected in series, the negative terminal, i.e. the ground, of the fifth cell will be at a potential of approximately 8 volts and the positive terminal will be at a potential of approximately 10 volts, whereas the negative terminal of the seventh cell will be at a potential of approximately 12 volts and the positive terminal will be at a potential of approximately 14 volts. This has led to the common misconception in the art that the cell monitoring devices have to be electrically isolated from each other and from the central battery monitoring system.

In one known cell monitoring system, each cell is independently linked to its own electrically isolated input at the central monitoring system. The problem with this system is that a large number of connectors are needed to link the individual cell monitoring devices to the central monitoring system. Consequently, in practice, it is seldom used for permanent real-time monitoring of the battery cells.

In another known cell monitoring system, each cell monitoring device is serially linked to its neighbours in a daisy-chain configuration, either by using optical links between the monitoring devices or by using transformers which have no DC path. The problem with this system is that to operate, each of the cell monitoring devices requires either an electrical to optical and an optical to electrical converter or a modulator and a demodulator, which makes them relatively expensive and inefficient since this additional circuitry requires more power from the cell.

There is therefore a need to provide a simple cell monitoring device which can monitor and report on the status of the cells of the battery, but which consumes minimal power from the cell which it is monitoring.

The inventor has realised that it is possible to overcome the problem of having the cell monitoring devices operating at different voltages using simple electronic components and that therefore, there is no need for electrical isolation between the individual cell monitoring devices and the central monitoring system.

The applicant has proposed a solution to this problem in PCT/GB98/00170 which uses a number of cell signalling devices, each to be powered by a respective one or more of the battery cells and a communications link connecting the cell signalling devices in a daisy chain configuration, and wherein each cell signalling device comprises a DC level shift circuit which is operable to receive signals transmitted from an adjacent cell signalling device, to shift the DC level of the received signals and to output the level shifted signals for transmission to the next cell signalling device. As suitable DC level shift circuits, the application proposes, among others, voltage comparators. However, the use of such voltage comparators to shift the DC level is not practical where there are large differences in voltage levels between adjacent cell signalling devices or where there are a large number of cell signalling devices connected in series.

According to one aspect, the present invention provides a signalling system for use with a plurality of systems each having a respective power source and each operating at a different reference potential, the system comprising:
first and second signalling devices each to be powered by a respective one or more of said plurality of systems; and
an electrically conductive link for connecting an output terminal of said first signalling device to an input terminal of said second signalling device;
wherein said first signalling device comprises:
i) a supply terminal and a reference terminal for receiving power from said respective one of more of said plurality of systems and for providing a supply potential and a reference potential to said first signalling device;
ii) means for varying the impedance of said output terminal comprising: a solid state switch having first and second main electrodes and a control electrode, the first main electrode being connected to said supply terminal of the first signalling device and the second main electrode being connected to said output terminal of said first signalling device; and
iii) a controller for applying a control signal to said control electrode for opening and closing said solid state switch in dependence upon a signal to be transmitted from said first signalling device to said second signalling device;
wherein said second signalling device comprises:
i) a supply terminal and a reference terminal for receiving power from said respective one or more of said plurality of systems and for providing a supply potential and a reference potential to said second signalling device; and
ii) a sensor coupled to said input terminal for sensing the signal transmitted from said output terminal of said first signaling device to said input terminal of said second signalling device by sensing the variation of impedance of said output terminal and for outputting a signal which varies in dependence upon the sensed signal, and
wherein said input terminal of said second signalling device is connected to the reference terminal of said second signalling device.

The present invention also provides a signalling system for use with a plurality of systems each having a respective power source and each operating at a different reference potential, the system comprising:
first and second signalling devices each to be powered by a respective one or more of said plurality of systems; and
an electrically conductive link for connecting an output terminal of said first signalling device to an input terminal of said second signalling device;
wherein said first signalling device comprises:
i) a supply terminal and a reference terminal for receiving power from said respective one of more of said plurality of systems and for providing a supply potential and a reference potential to said first signalling device;
ii) means for varying the impedance of said output terminal comprising; a solid state switch having first and second main electrodes and a control electrode, the first main electrode being connected to said reference terminal of the first signalling device and the second main electrode being connected to said output terminal of said first signalling device; and
iii) a controller for applying a control signal to said control electrode for opening and closing said solid state switch in dependence upon a signal to be transmitted from said first signalling device to said second signalling device;
wherein said second signalling device comprises:
i) a supply terminal and a reference terminal for receiving power from said respective one or more of said plurality of systems and for providing a supply potential and a reference potential to said second signalling device; and
ii) a sensor coupled to said input terminal for sensing the signal transmitted from said output terminal of said first signalling device to said input terminal of said second signalling device by sensing the variation of impedance of said output terminal and for outputting a signal which varies in dependence upon the sensed signal; and
wherein said input terminal of said second signalling device is connected to the supply terminal of said second signalling device.

The present invention will now be described, by way of example only, with reference to the accompanying drawings, in which:
Figure 1 schematically shows a battery comprising a number of battery cells connected in series, a central battery monitoring system for monitoring the condition of the battery as a whole and individual cell monitoring devices for monitoring the cells of the battery;
Figure 2 is a plot showing the battery-cell voltage distribution;
Figure 3 is a schematic diagram showing more detail of the central battery monitoring system shown in Figure 1;
Figure 4 is a schematic diagram of one of the cell monitoring devices shown in Figure 1;
Figure 5 schematically illustrates the way in which signals are passed between adjacent cell signalling devices in a first embodiment of the invention;
Figure 6 schematically illustrates the form of a cell monitoring device according to a second embodiment and the way in which it is connected to neighbouring cell monitoring devices;
Figure 7 schematically illustrates an alternative way in which signals can be transmitted between adjacent cell signalling devices;
Figure 8 is a schematic diagram of a battery cell monitoring device for use in a battery monitoring system according to a second embodiment of the present invention;
Figure 9 schematically shows a battery comprising a number of battery cells connected in series, a central battery control system for controlling the battery as a whole and individual battery cell controllers for controlling the cells of the battery;
Figure 10 is a schematic diagram ot one of the battery cell control devices shown in Figure 9;
Figure 11 is a schematic diagram of a battery cell monitoring and control device for use in a battery monitoring and control system embodying the present invention:
Figure 12 is a schematic representation of an industrial battery in which the cells or the battery are connected in a series-parallel configuration; and
Figure 13 is a schematic diagram of a system for monitoring a plurality of industrial batteries.

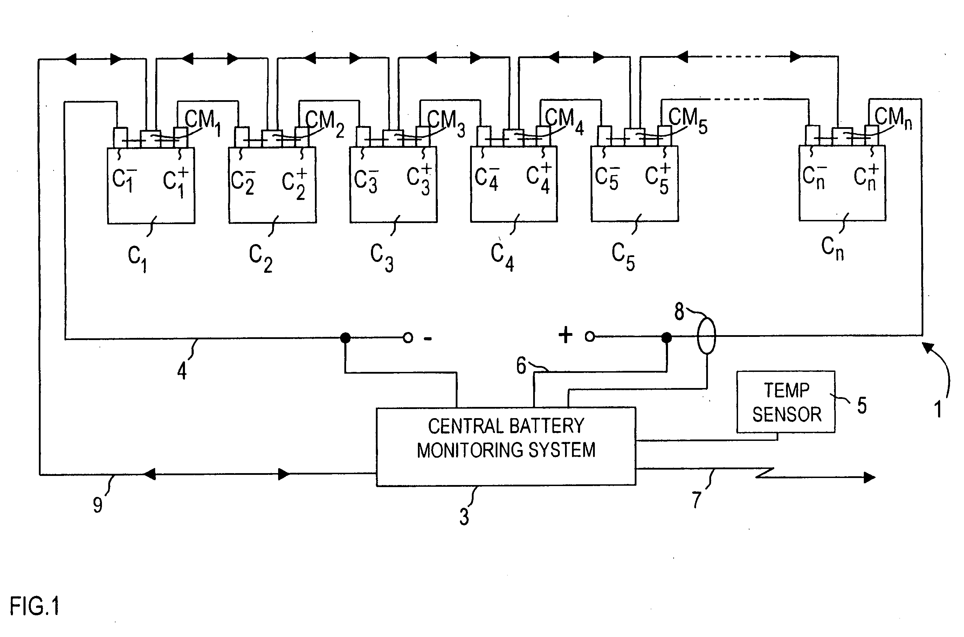

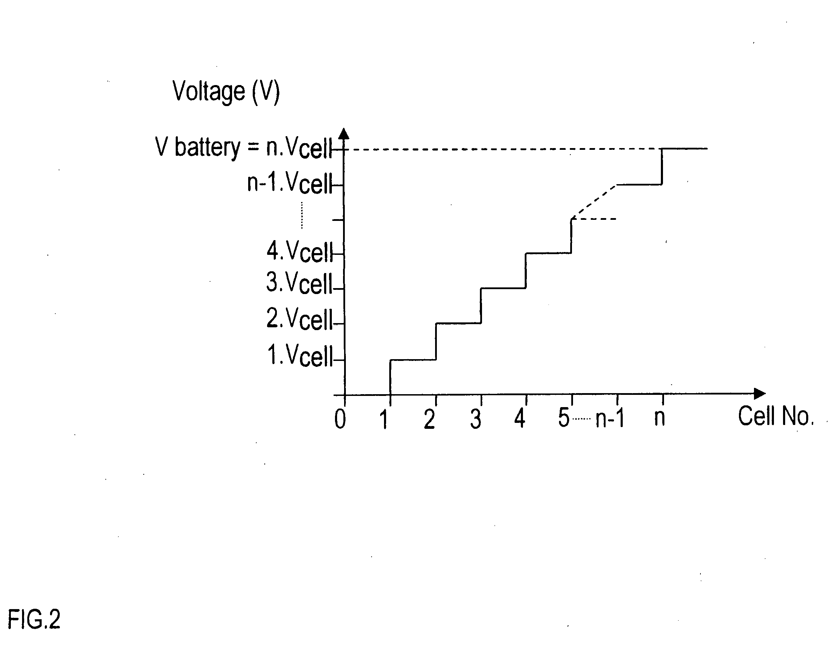

A first embodiment of the present invention will now be described with reference to Figures 1 to 5. Figure 1 schematically shows an industrial battery, generally indicated by reference numeral 1, comprising a number of lead acid battery cells C₁, C₂, C₃ ... Cₙ connected so that the negative terminal Cᵢ⁻ of cell Cᵢ is connected to the positive terminal Cᵢ₋₁⁺ of preceding cell Cᵢ₋₁ and the positive terminal C₁⁺ of cell Cᵢ is connected to the negative terminal Cᵢ₊₁⁻ of the succeeding cell Cᵢ₊₁, whereby the negative terminal Cᵢ⁻ of the first cell Cᵢ is the negative terminal of the battery and the positive terminal Cₙ⁺ of Lhe last cell Cₙ is the positive terminal of the battery. Since the battery cells are lead acid, they each provide approximately 2 volts and the voltage of the battery as a whole will be approximately 2n volts- Figure 2 shows the voltage characteristic of the industrial battery showing each cell's terminal potential versus the cell's position i.n the series. As shown, this voltage characteristic has a staircase share, with each stair having a height equal to the voltage V_{CELL} of the respective battery cell Cᵢ. For industrial applications a voltage of 120 volts is often required. Therefore, 60. series connected lead acid of 100 series connected Nicad battery cells would be required. Sometimes, each cell in the series connection is connected in parallel with one or more similar cells, so as to provide redundancy, so that the battery will not fail if a single cell fails. Figure 1 also shows a central battery monitoring system 3 which is powered by the battery 1 via connectors 4 and 6, which connect the central battery monitoring system 3 to the negative terminal C₁⁻ and the positive terminal Cₙ⁺ of the battery 1, respectively. The battery monitoring system 3 monitors the status of the industrial battery 1 as a whole, based on charging and discharging characteristics of the battery (determined by monitoring the battery voltage from connectors 4 and 6 and the current being drawn from or supplied to the battery 1, which is sensed by current sensor 8, whilst the battery is being charged and subsequently discharged), the ambient temperature (input from temperature sensor 5) and on information relating to the efficiency characteristics of the battery cells (provided by the battery cell manufacturer). The monitoring results can be stored in the central battery monitoring system 3 or they can be transmitted to a remote user (not shown) via the telephone line 7.

Each of the battery cells Cᵢ, shown in Figure 1, also has a battery cell monitoring device CMᵢ mounted on top of the cell between its positive and negative terminals Cᵢ⁺ and Cᵢ⁻ respectively, which monitors the status of the cell Cᵢ. Each cell monitoring device CMᵢ is powered by the cell Cᵢ which it monitors and communicates with the central battery monitoring system 3 via a two-wire communication link 9. The communication link 9 links the cell monitoring devices CMᵢ in series in a daisy chain configuration to the central battery monitoring system 3, so that communications from the central battery monitoring system 3 to the cell monitoring devices CMᵢ pass on one wire from left to right along the communication link 9 and communications from the cell monitoring devices CMᵢ to the central battery monitoring system 3 pass on the other wire from right to left along the communication link 9. Each cell monitoring device CMᵢ has its own cell identification or address, which, in this embodiment, is set in advance using DIP-switches mounted in the device. This allows communications from the central battery monitoring system 3 to be directed to a specific cell monitoring device and allows the central battery monitoring system 3 to be able to identify the source of received communications.

The battery monitoring system shown in Figure 1 operates in two modes. In the first mode, the central battery monitoring system 3 monitors the condition of the industrial battery 1 as a whole and polls each of the cell monitoring devices CMᵢ in turn. During this mode, each of the cell monitoring devices CMᵢ listens to communications from the central battery monitoring system 3 on the communication link 9 and responds when it identifies a communication directed to it. When polled, each cell monitoring device CMᵢ performs a number of tests on the corresponding battery cell Cᵢ and returns the results of the tests back to the central battery monitoring system 3 via the communication link 9.

In the second mode of operation, the central battery monitoring system 3 listens for communications on the communication link 9 from the cell monitoring devices CMᵢ indicating that there is a faulty condition with one of the battery cells Cᵢ. In this second mode of operation, each cell monitoring device CMᵢ continuously monitors the corresponding battery cell Cᵢ and, upon detection of a faulty condition, checks that the communication link 9 is free and then sends an appropriate message back to the central battery monitoring system 3 via the communication link 9.

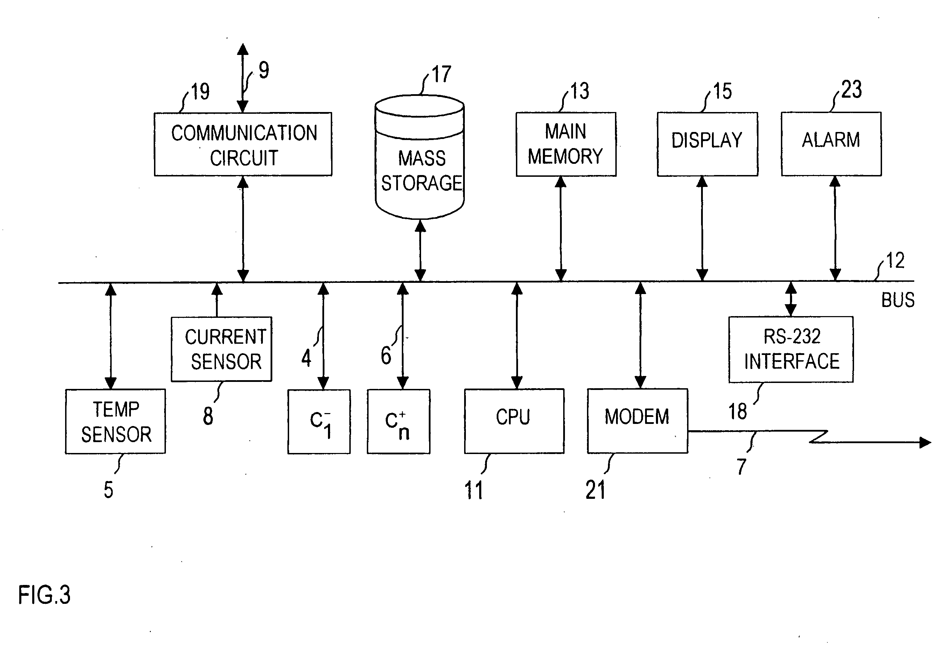

Figure 3 is a schematic diagram of the central battery monitoring system 3 shown in Figure 1. As shown, the central battery monitoring system 3 comprises a CPU 11 for controlling the operation of the central battery monitoring system 3. The CPU 11 is connected, via data bus 12, to a main memory 13 where data from the input sensors is stored and where test programs are executed, to a display 15 which displays the battery's current status and to a mass storage unit 17 for storing the sensor data and the results of the battery tests. The mass storage unit 17 can be fixed within the central battery monitoring system 3, but is preferably a floppy disk or a PCMIA memory card which can be withdrawn and input into an operator's personal computer for analysis. An operator can also retrieve the stored data and results and control the set up and initialisation of the central battery monitoring system 3 via the RS-232 serial interface 18. As mentioned above, instead of storing the test results in the mass storage unit 17, they can be transmitted via a modem 21 and telephone line 7 to a remote computer system (not shown) for display and/or analysis. In this embodiment, if there is a fault with one of the battery cells Cᵢ or if there is some other faulty condition, the CPU 11 triggers a local alarm 23 to alert a technician that there is a fault with the battery 1 or with one or more of the battery cells Cᵢ. In this embodiment, the conditions which define a fault and their thresholds are user definable and set in advance.

The central battery monitoring system measures the total battery capacity in Amp-hours (Ahr) or Watt-hours (Whr), the actual or remaining battery capacity as a percentage of the total battery capacity and the internal resistance of the battery 1 as a whole. The cental battery monitoring system 3 can also measure the internal resistance of the individual cells from the data received from the individual cell monitoring devices CMᵢ received via the communication link 9 and the communication circuit 19. Although the central battery monitoring system 3 continuously monitors the battery 1, the sensor data and the other battery data, i.e. the remaining battery capacity etc, are only stored periodically in the mass storage unit 17 in order to save storage space. The period is specified in advance by the user and in this embodiment is set at ten seconds. Furthermore, when the samples are stored, they are time and date stamped so that the battery charging and discharging behaviour can be monitored and used to detect the cause of an eventual battery failure. In this embodiment, the data which is to be stored is also filtered in order to try to identify and highlight important events, and the filtered data is also stored in the mass storage unit 17. What counts as an important event is user definable, but can be, for instance, a temperature increase of 2°C or a change in remaining battery capacity of greater than 1% of the total battery capacity.

As mentioned above, the status data of the battery, i.e. the battery voltage, the discharge/charge current, the battery temperature and the remaining and total battery capacities, are displayed on display 15. For simplicity, since the display 15 does not need to be continuously updated, it is only updated using the samples of the status data which are to be stored in mass storage unit 17. Therefore, in this embodiment, the display 15 is updated every ten seconds.

In this embodiment, the central battery monitoring system 3 is also used to control the battery charger (not shown) which is used to charge the battery 1. In particular, the central battery monitoring system 3 monitors the charging current, the remaining battery capacity, the ambient temperature etc and controls the operation of the charger (not shown) so that the battery charging is in accordance with the specific charging procedures recommended by the battery manufacturer for the battery 1.

Since the total battery capacity also decreases with time (due to ageing), the central battery monitoring system 3 is programmed to perform regular (for example daily or monthly) automated measurements of the total battery capacity and the battery internal resistance. This allows the central battery monitoring system 3 to be able to build up a picture of the battery life characteristics and to be able to predict the battery end of life and the early detection of faulty conditions.

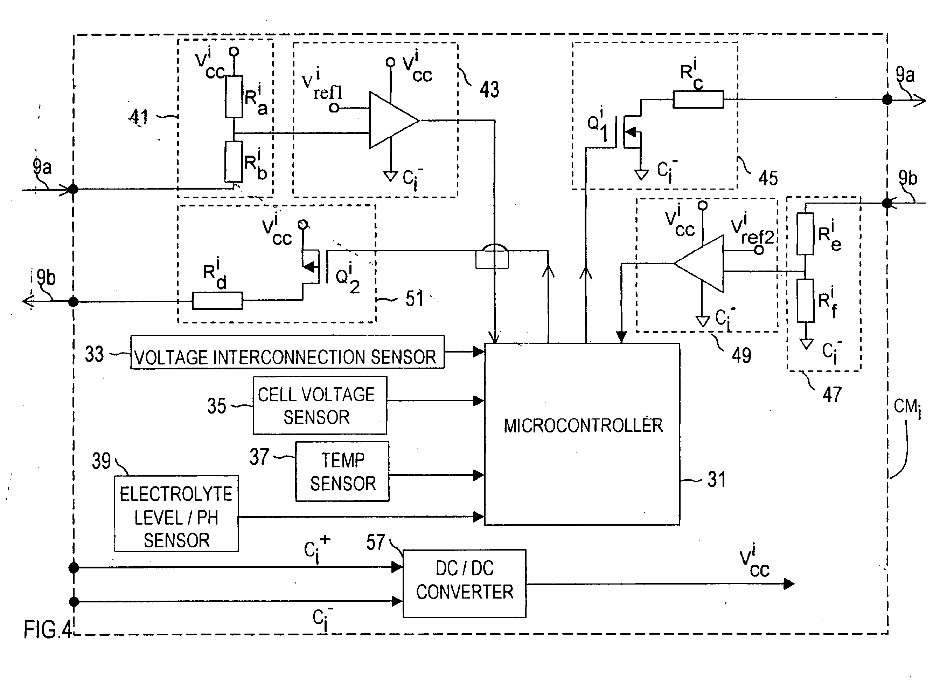

Figure 4 is a schematic diagram showing, in more detail, one of the cell monitoring devices CMᵢ shown in Figure 1. As shown, cell monitoring device CMᵢ comprises a microcontroller 31 for controlling the operation of the cell monitoring device CMᵢ and for analysing sensor data received from voltage interconnection sensor 33, cell voltage sensor 35, temperature sensor 37 and electrolyte level/PH sensor 39.

The voltage interconnection sensor 33 measures the voltage drop between the cell being monitored and its neighbouring cells, by measuring the potential difference between each terminal of the cell Cᵢ and the respective terminal connections which connects cell Cᵢ with its neighbouring cells. Ideally, there should be no voltage drop between each terminal and the corresponding terminal connection. However, due to chemical deposits accumulating at the cell terminals with time, or because of cell malfunction, a difference in potential between the cell terminals and the corresponding connectors sometimes exists, indicating that there is a fault, either with the battery cell Cᵢ or with the interconnection with a neighbouring cell. The cell voltage sensor 35 is provided for sensing the potential difference between the positive terminal Cᵢ⁺ and the negative terminal Cᵢ⁻ of the cell Cᵢ which it is monitoring. The temperature sensor 37 senses the cell temperature locally at the cell Cᵢ. By monitoring the local temperature at each cell Cᵢ, it is possible to identify quickly faulty cells or cells which are not operating efficiently. The electrolyte level/PH sensor senses the electrolyte level and/or the electrolyte PH of the battery cell Cᵢ which it is monitoring.

The microcontroller 31 analyses the data input from the sensors and monitors for faulty conditions and reports to the central battery monitoring system 3 via the communication link 9. Since the microcontroller 31 processes digital data, and since the signals received from the sensors and the messages received from the battery monitoring system 3 are analogue signals, the microcontroller 31 has a built-in analogue to digital convertor (not shown) so that it can convert the sensor data and the received messages into corresponding digital signals. In order to power the cell monitoring device CMᵢ, the positive terminal Cᵢ⁺ and the negative terminal Cᵢ⁻ of cell Cᵢ are connected to the input of a DC to DC convertor 57, which generates, relative to the ground of cell Cᵢ (which equals the voltage potential of the negative terminal Cᵢ⁻ of cell Cᵢ) the voltage V_{cc}ⁱ, which is used to power the microcontroller 31 and the other components in the device and which in this embodiment is Cᵢ⁻ + 3 Volts.

Since the cell monitoring devices are connected in series by the communication link 9, each cell monitoring device CMᵢ is operable (i) to receive up-link communications originating from the central battery monitoring system 3 on wire 9a of the communication link 9 for reception by itself and/or for onward transmission to the next cell monitoring device CMᵢ₊₁; (ii) to receive down-link communications from cell monitoring device CMᵢ₊₁ on wire 9b of the communication link 9 for transmission back to the central battery monitoring system 3; and (iii) to transmit down-link communications generated by itself back to the central battery monitoring system 3 on wire 9b of the communication link 9.

As shown in Figure 4, in this embodiment, the microcontroller 31 receives up-link communications originating from the central battery monitoring system 3 via wire 9a, potential divider 41 and comparator 43. The microcontroller 31 identifies whether or not the received message from the central battery monitoring system is for it or if it is for onward transmission to the next cell monitoring device CMᵢ₊₁. If the message is for the current cell monitoring device CMᵢ, then the microcontroller 31 decodes the message and takes the appropriate action. If the received message is for onward transmission, then the microcontroller 31 regenerates the message and outputs it to wire 9a via output block 45. In this embodiment, the messages transmitted are square-wave signals representing digital data. The signals are encoded for error correction purposes and the microcontroller 31 checks for errors in the received messages. Since the microcontroller 31 regenerates the messages for transmission to the next cell monitoring device CMᵢ₊₁, the timing between the transitions in the signal levels can be resynchronised, thereby reducing any errors caused by the transmission of the pulses along the communication link 9.

In a similar manner, down-link messages received from cell monitoring device CMᵢ₊₁ on wire 9b are passed via potential divider 47 and comparator 49 to the microcontroller 31. In this embodiment, all down-link communications are for transmission back to the central battery monitoring system 3. Therefore, the micro-controller 31 checks for any errors in the received data and, if possible, corrects them. The microprocessor 31 then regenerates the message and outputs it to wire 9b via output block 51 for onward transmission back to the central battery monitoring system 3.

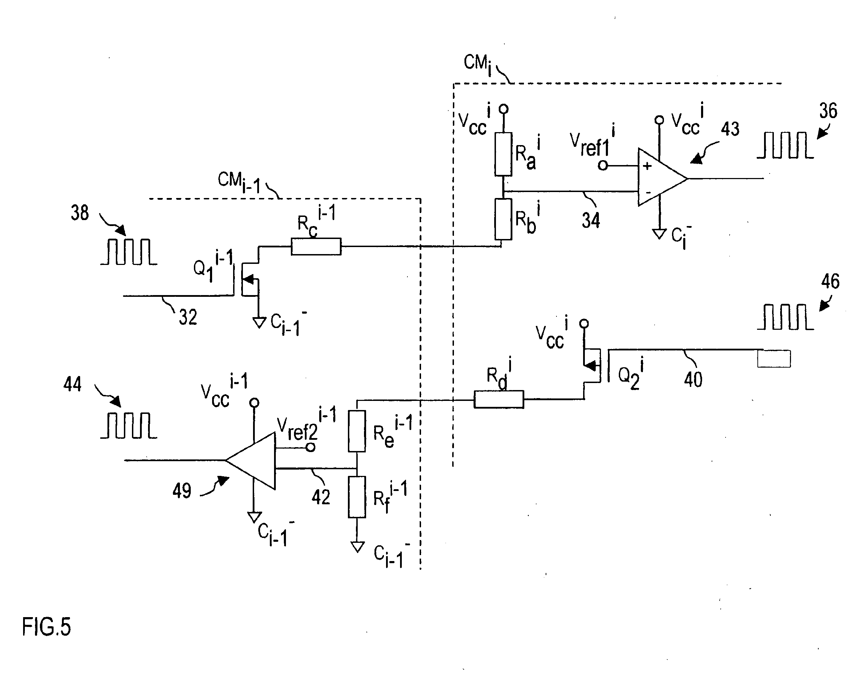

The way in which the messages are transmitted between the cell monitoring devices will now be described in more detail with reference to Figure 5. Up-link messages originating from the central battery monitoring system 3 which are re-transmitted by the microcontroller 31 of cell monitoring device CMᵢ₋₁ are applied on line 32 to the gate electrode of the MOSFET Q₁ⁱ⁻¹. The source electrode of the MOSFET Q₁ⁱ⁻¹ is connected to the ground Cᵢ₋₁⁻ of cell monitoring device CMᵢ₋₁ and the drain electrode is connected, via resistors Rₐⁱ, R_{b}ⁱ and R_{c}ⁱ⁻¹, to V_{cc}ⁱ output by the DC/DC converter 57 in cell monitoring device CMᵢ. In operation, when the microcontroller 31 in the cell monitoring device CMᵢ₋₁ outputs a voltage low (representing a binary 0) on line 32, the MOSFET Q₁ⁱ⁻¹ does not allow current to flow from the drain electrode to the source electrode and therefore effectively open circuits the connection between V_{cc}ⁱ and Cᵢ₋₁⁻. Therefore, when a voltage low is applied to the gate electrode of MOSFET Q₁ⁱ⁻¹, a voltage of approximately V_{cc}ⁱ is applied on line 34 to the comparator 43, where it is compared with reference voltage V_{refl}ⁱ. When the microprocessor 31 of cell monitoring device CMᵢ₋₁ outputs a voltage high (representing a binary 1) on line 32, the MOSFET Q₁ⁱ⁻¹ is switched on and current can flow from the drain electrode to the source electrode. Therefore, current will flow from V_{cc}ⁱ through resistors Rₐⁱ, R_{b}ⁱ and R_{c}ⁱ⁻¹ through the MOSFET Q₁ⁱ⁻¹ to the ground Cᵢ₋ₗ⁻ of cell monitoring device CMᵢ₋₁. As a result, V_{cc}ⁱ - X volts will be applied on line 34 to the comparator 43, where it is compared with the reference voltage V_{refl}ⁱ. The value of X depends upon the difference between V_{cc}ⁱ and Cᵢ₋₁⁻ and the values of the resistors Rₐⁱ, R_{b}ⁱ and R_{c}ⁱ⁻¹. Provided the value of the reference voltage V_{refl}ⁱ is between the voltage levels applied to the comparator 43 on line 34 when the MOSFET Q₁ⁱ⁻¹ is switched on and when it is switched off, the output of the comparator 43 will be a square-wave signal 36 varying between the ground potential Cᵢ⁻ and V_{cc}ⁱ of cell monitoring device CMᵢ in synchronism with the variation of the square-wave signal 38 applied to the gate electrode of MOSFET Q₁ⁱ⁻¹ of cell monitoring device CMᵢ₋₁. Therefore, messages encoded within the variation of the signal applied to the MOSFET Q₁ⁱ⁻¹ in cell monitoring device CMᵢ₋₁ are transferred from cell monitoring device CMᵢ₋₁ to cell monitoring device CMᵢ.

In a similar manner, down-link messages output by the microcontroller 31 in cell monitoring device CMᵢ for transmission back to the central battery monitoring system 3 are applied to the gate electrode of MOSFET Q₂ⁱ on line 40. The drain electrode of MOSFET Q₂ⁱ is raised to the potential V_{cc}ⁱ and the source is connected, via resistors R_{d}ⁱ, Rₑⁱ⁻¹ and R_{f}ⁱ⁻¹, to the ground potential Cᵢ₋₁-of cell monitoring device CMᵢ₋₁. In operation, when the microcontroller 31 in the cell monitoring device CMᵢ outputs a voltage low on line 40, the MOSFET Q₂ⁱ does not allow current to flow from the drain electrode to the source electrode and therefore effectively open circuits the connection between V_{cc}ⁱ and Cᵢ₋₁⁻. Therefore, when a voltage low is applied to the gate electrode of MOSFET Q₂ⁱ, approximately zero volts is applied on line 42 to the comparator 49, where it is compared with reference voltage V_{ref2}ⁱ⁻¹. When the microcontroller 31 of cell monitoring device CMᵢ outputs a voltage high on line 40, the MOSFET Q₂ⁱ is switched on and current flows from V_{cc}ⁱ through resistors R_{d}ⁱ, Rₑⁱ⁻¹ and R_{f}ⁱ⁻¹ to the ground Cᵢ₋₁⁻ of the cell monitoring device CMᵢ₋₁. As a result, V_{cc}ⁱ - Y volts will be applied on line 42 to the comparator 49, where it is compared with the reference voltage V_{ref2}ⁱ⁻¹. The value of Y depends upon the difference between V_{cc}ⁱ and Cᵢ₋₁⁻ and the values of resistors R_{d}ⁱ, Rₑⁱ⁻¹ and R_{f}ⁱ⁻¹. Again, provided the value of the reference voltage V_{ref2}ⁱ⁻¹ is between the voltage levels applied to the comparator 49 on line 42 when the MOSFET Q₂ⁱ is switched on and when it is switched off, the output of the comparator 49 will be a square-wave signal 44 varying between the ground potential Cᵢ₋₁⁻ and V_{cc}ⁱ⁻¹ of cell monitoring device CMᵢ₋₁ in synchronism with the variation of the signal 46 applied to the gate electrode of MOSFET Q₂ⁱ of cell monitoring device CMᵢ. Therefore, messages encoded within the variation of the signal applied to MOSFET Q₂ⁱ are transferred from cell monitoring device CMᵢ to cell monitoring device CMᵢ₋₁.

The values of the resistors Rₐⁱ to R_{f}ⁱ in each cell monitoring device CMᵢ are chosen in order (i) to buffer the input and output terminals of the cell monitoring devices CMᵢ; (ii) to reduce power consumption of the cell monitoring devices CMᵢ; and (iii) to provide the necessary voltage division with respect to the difference in voltage between adjacent cell monitoring devices.

As those skilled in the art will appreciate, the above technique for transferring up-link and down-link data between cell monitoring devices CMᵢ₋₁ and CMᵢ will only work provided the difference between V_{cc}ⁱ and Cᵢ₋₁⁻ does not exceed the operating range of the MOSFET switches Q₁ⁱ⁻¹ and Q₂ⁱ. In this embodiment, each battery cell Cᵢ is provided with a cell monitoring device CMᵢ, the difference in operating potentials of adjacent cell monitoring devices is approximately two volts and V_{cc}ⁱ is three volts more than the ground potential of the cell monitoring device. Therefore, in this embodiment, the difference between V_{cc}ⁱ and Cᵢ₋₁⁻ is approximately five volts. MOSFET transistors Q which can operate with such a loading are readily available. Indeed, there are some commercially available MOSFETs which can operate with a loading of up to sixty volts. Therefore, this technique of transmitting data between adjacent cell monitoring devices can be used in most practical situations, even in an embodiment where, for example, one cell monitoring device is provided for every tenth battery cell Cᵢ.

Each of the cell monitoring devices CMᵢ operate in a similar manner. However, it should be noted, that in this embodiment, the first cell monitoring device CM₁ has the same ground or reference voltage as the central battery monitoring system 3. Therefore, in this embodiment, it is not necessary to use the potential divider 41 and the comparator 43 of the up-link nor the output block 51 in the down-link of the first cell monitoring device CM₁, although these are usually provided in order to standardise each of the cell monitoring devices CMᵢ. Similarly, the last cell monitoring device CMₙ will not transmit data to nor receive data from a subsequent cell monitoring device. Therefore, cell monitoring device CMₙ does not need the output block 45 in the up-link nor the potential divider 47 and the comparator 49 in the down-link. However, these are usually provided so that all the cell monitoring devices CMᵢ are the same.

The battery monitoring system described above has the following advantages:
(1) There is no need for voltage isolation between the cell monitoring devices CMᵢ or between the first cell monitoring device CM₁ and the central battery monitoring system 3. Therefore, each cell monitoring device CMᵢ will only consume a few milli-amps and only requires very inexpensive and readily available DC to DC converters for converting the battery cell voltage to the supply voltage needed by the microcontroller 31.
(2) Since electrical isolation is not required between the cell monitoring devices CMᵢ, there is no longer a need for relatively expensive voltage isolated links between the cell monitoring devices. In the embodiment described, each cell monitoring device CMᵢ is linked to its neighbours by two wires. The cost of the battery monitoring system is therefore low and system installation is simplified.
(3) Continuous monitoring of all the cells Cᵢ in battery 1 becomes economical and practical, and the user can be informed in real-time if one or more of the battery cells Cᵢ is under-performing or is faulty.
(4) The internal resistance of each cell Cᵢ can be determined in real-time and without having to disconnect the cell from the battery, since the central battery monitoring system 3 is capable of measuring battery charging and discharging current (which is the same as the cell current) and can correlate it with individual cell voltages (determined by the cell monitoring devices) in order to calculate each cell's internal resistance.
(5) Each cell monitoring device CMᵢ is able to measure the voltage drop on cell to cell interconnections and indicate a faulty interconnection condition, usually due to chemical deposits accumulating at the cell terminals with time or because of cell malfunction.
(6) Since each cell monitoring device CMᵢ is able to measure the cell voltage and the cell temperature, it is possible to increase the probability of detecting a faulty cell. Therefore, the industrial battery need only be serviced when required.
(7) Since each cell monitoring device CMᵢ can read the corresponding cell voltage, cell temperature etc at the same time as the other cell monitoring devices, the data produced by each cell monitoring device is less likely to be corrupted by changes in load and/or changes in ambient temperature which occur with time, as compared with prior art systems which take readings from the individual cells one at a time.

A number of alternative embodiments will now be described, which operate in a similar manner to the first embodiment. Accordingly, the description of these alternative embodiments will be restricted to features which are different to those of the first embodiment.

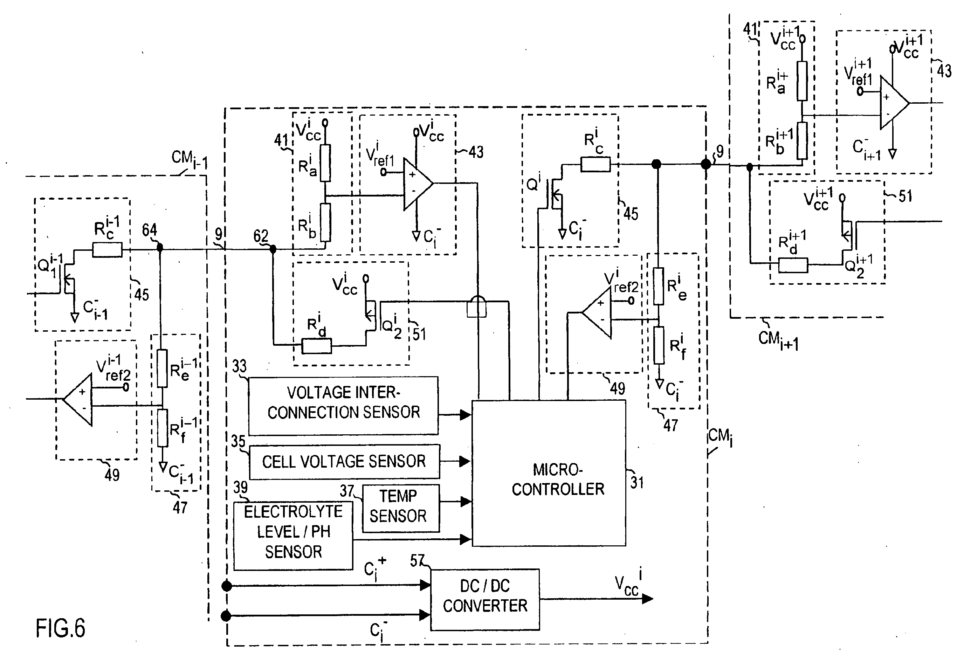

Figure 6 illustrates an embodiment in which messages can be transmitted uplink as well as downlink between adjacent cell monitoring devices CMᵢ, via a single communication wire 9 which connects the cell monitoring devices in series. As shown in Figure 6, each cell monitoring device CMᵢ has the same potential dividers 41 and 49, comparators 43 and 47, and output blocks 45 and 51 as in the first embodiment. The difference between this embodiment and the first embodiment is that the uplink and the downlink between adjacent cell monitoring devices share a common communication wire 9. This is achieved by connecting, at connection 62, the output of block 51 in cell monitoring device CMᵢ to the connection between potential divider 41 in cell monitoring device CMᵢ and the output block 45 in cell monitoring device CMᵢ₋₁ and by connecting, at connection 64, the potential divider 49 in cell monitoring device CMᵢ₋₁ to the connection between potential divider 41 in cell monitoring device CMᵢ and the output block 45 in cell monitoring device CMᵢ₋₁.

Since both the uplink and the downlink connection between adjacent cell monitoring devices is via the same wire 9, communications between cell monitoring devices can be in one direction only at any given time. To achieve this, during a downlink communication, MOSFET Q₁ⁱ⁻¹ is switched off so that messages transmitted by switching the state of MOSFET Q₂ⁱ pass via the potential divider 49 and the comparator 47 into the microcontroller (not shown) in cell monitoring device CMᵢ₋₁. Similarly, for uplink communications from, for example, cell monitoring device CMᵢ to cell monitoring device CMᵢ₊₁, the MOSFET Q₂ⁱ⁺¹ is switched off so that the output block 51 has a high impedance and does not affect the operation of the potential divider 41. Further, as those skilled in the art will appreciate, in order for the potential dividers and output blocks to operate in the same way as in the first embodiment, the resistances of resistors Rₐ, R_{b}, Rₑ and R_{f} must be relatively large compared to the resistances of resistors R_{c} and R_{d}. In this embodiment, with 2 volt battery cell voltages, Rₐ = R_{b} = Rₑ = R_{f} = 10K ohms, R_{d} = R_{c} = 2K ohms, V_{ref1}ⁱ = V_{ref2}ⁱ = V_{cc}ⁱ/2 and V_{cc}ⁱ = Cᵢ⁻+ 5V. As those skilled in the art will appreciate, the cell monitoring device of this embodiment can easily be adapted to operate with any battery cell voltage, the only changes that are required are the resistor values, the reference voltage values and the maximum allowable drain to source voltage of the MOSFETs.

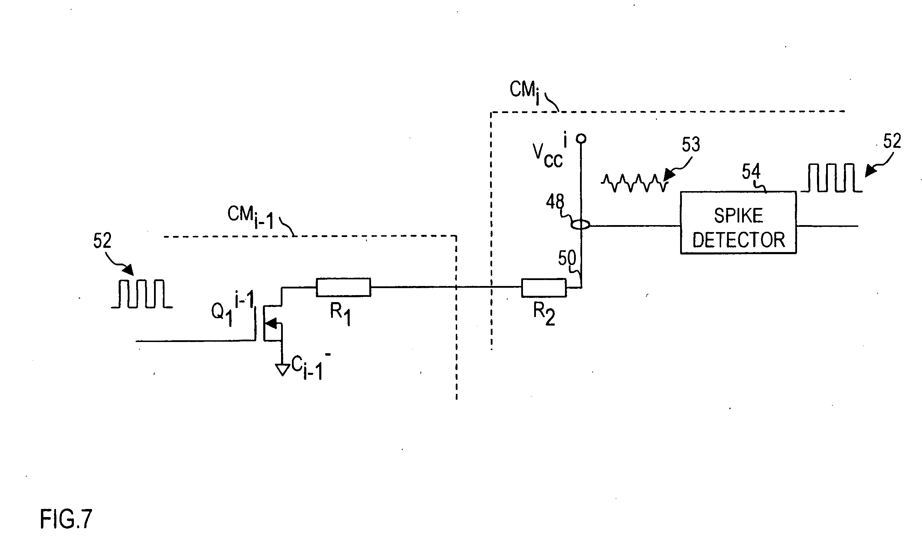

As those skilled in the art will appreciate, in the above embodiments, data was transmitted between adjacent cell monitoring devices by varying the output impedance of an output block in the cell monitoring device which is to transmit the message and by detecting this variation in the cell monitoring device which is to receive the message. For example, when up-link message data is to be transmitted from cell monitoring device CMᵢ₋₁ to cell monitoring device CMᵢ, the impedance of output block 45 in cell monitoring device CMᵢ₋₁ is varied in dependence upon the data to be transmitted - when a voltage low is to be transmitted, the impedance of output block 45 is made to be very high, whereas when a voltage high is to be transmitted, the impedance of output block 45 is made to be relatively low. This variation of the impedance of output block 45 is detected by the potential divider 41 and the comparator 43 in the cell monitoring device CMᵢ which is to receive the transmitted up-link message. As those skilled in the art will appreciate, there are various ways of varying an output impedance of a cell monitoring device in dependence upon the data to be transmitted and various ways of detecting that variation in the adjacent cell monitoring device. Figure 7 shows one of these alternative embodiments.

In the embodiment shown in Figure 7, the output impedance of cell monitoring device CMᵢ₋₁ is varied in the same way as it was varied in the first embodiment but this variation is detected in cell monitoring device CM₁ in a different manner. In particular, in this embodiment, a current detector 48 is used to detect the changes in current flowing between the V_{cc}ⁱ terminal in cell monitoring device CMᵢ to the ground potential Cᵢ₋₁⁻ in cell monitoring device CMᵢ₋₁. In operation, when a voltage low is applied to the gate electrode of MOSFET Q₁ⁱ⁻¹, the MOSFET is open and no current flows down line 50. However, when a voltage high is applied to the gate electrode of MOSFET Q₁ⁱ⁻¹, the MOSFET opens and current is drawn down line 50. This change in current is detected by the current sensor 48. More specifically, each time there is a transition from a voltage high to a voltage low (or vice versa) applied to the gate electrode of MOSFET Q₁ⁱ⁻¹, a voltage spike is induced in the current detector 48. As illustrated in Figure 7, in response to up-link message data 52 being applied to the MOSFET Q₁ⁱ⁻¹, a train of voltage spikes 53 are induced in the current detector 48 and passed to a spike detector 54 which regenerates and outputs the up-link message data 52 for transmission to the microcontroller (not shown). The resistors R₁ and R₂ are provided in order to reduce the power consumed by each of the cell monitoring devices CMᵢ and in order to buffer the input and output of the respective cell monitoring devices.

In the above embodiments, a MOSFET was used as a device whose impedance can be varied in dependence upon the message data to be transmitted. As those skilled in the art will appreciate, these MOSFETs can be replaced by any electronic switches (solid state relays, J-FETs, transistors etc.)

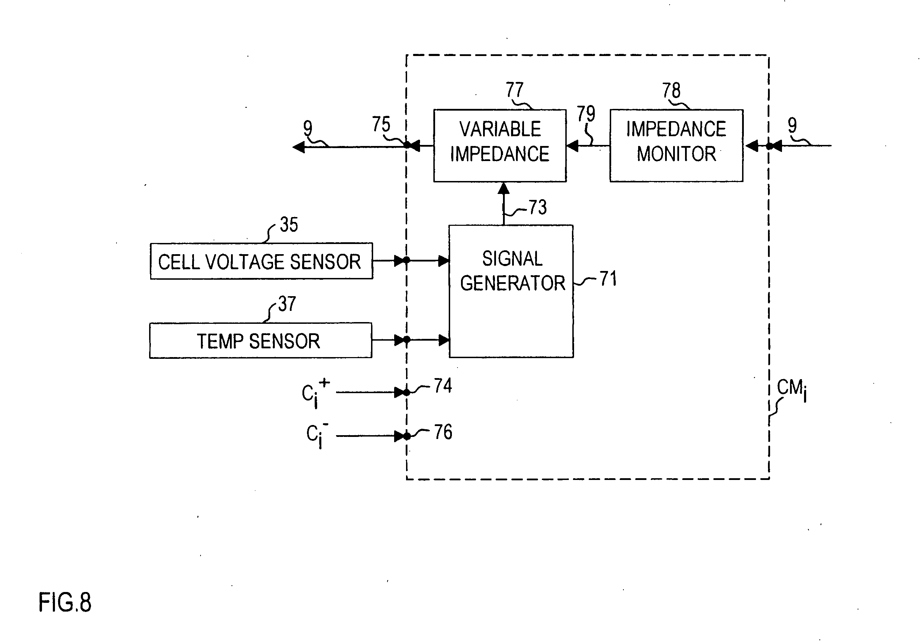

In the above embodiments, each cell monitoring device CMᵢ has a microcontroller 31 for receiving messages from the central battery monitoring system 3, for analysing data from various sensors and for sending data back to the central battery monitoring system 3 via the communication link 9. Figure 8 schematically shows an alternative cell monitoring device CMᵢ of a second embodiment which does not use a microcontroller 31.

In particular, as shown in Figure 8, each cell monitoring device comprises a signal generator 71 which receives sensor signals from the cell voltage sensor 35 and the temperature sensor 37 and outputs, on line 73, a signal which varies in dependence upon the received sensor signals. The signal generator 71 may comprise a voltage controlled oscillator which outputs an alternating signal whose frequency varies in dependence upon an input voltage from, for example, the cell voltages sensor 35.

The signal output from the signal generator 71 is applied to a variable impedance device 77 whose impedance is varied in dependence upon the signal output from the signal generator 71. The variation of the impedance of the variable impedance device 77 is detected by the cell monitoring device CMᵢ₋₁ to thereby regenerate the message transmitted by the signal generator 71. In order to be able to receive messages from cell monitoring device CMᵢ₊₁ for onward transmission back to the central battery monitoring system 3, as shown in Figure 8, each cell monitoring device CMᵢ also comprises an impedance monitor 78 which detects the variation of the impedance of the variable impedance device 77 in the cell monitoring device CMᵢ₊₁ from which it regenerates the message transmitted from cell monitoring device CMᵢ₊₁. This regenerated message is then applied via line 79 to the variable impedance device 77 for onward transmission to cell monitoring device CMᵢ₋₁. As in the first embodiment, each cell monitoring device CMᵢ is powered by the cell Cᵢ which it is monitoring. This is illustrated in Figure 8 by the connections Cᵢ⁺ and Cᵢ⁻ which are connected to input terminals 74 and 76 respectively.

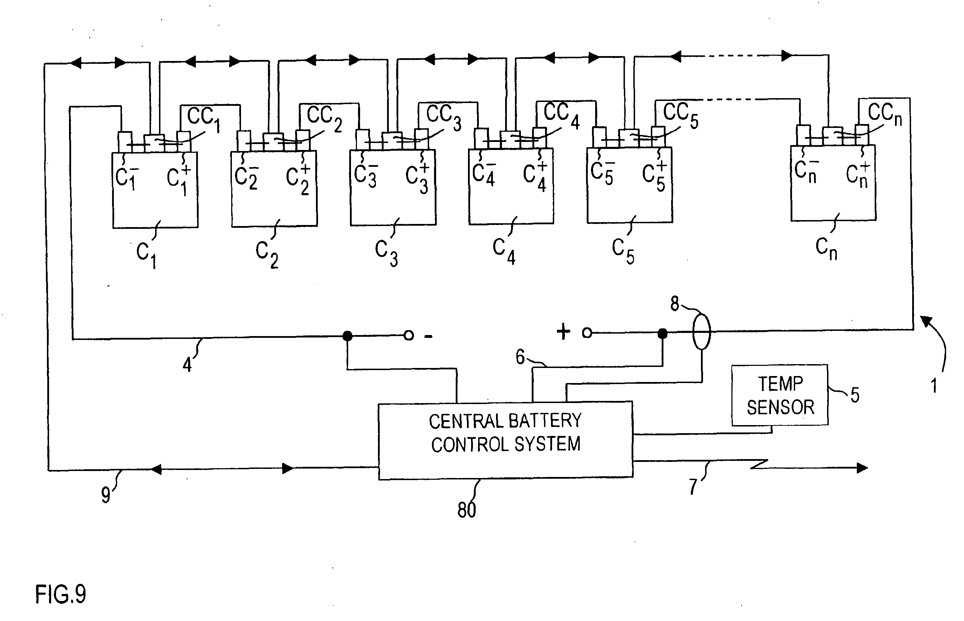

In the above embodiments, the system described was a battery monitoring system. Figure 9 schematically shows a third embodiment which is a control system for controlling the cells of an industrial battery. As shown, the control system has a similar architecture to the battery monitoring system shown in Figure 1, except that the central battery monitoring system 3 is now a central battery control system 80 and the cell monitoring devices CMᵢ are now battery cell control devices CCᵢ. As in the monitoring system of Figure 1, the central battery control system 80 communicates with each of the cell controlling devices CCᵢ via the communication link 9.

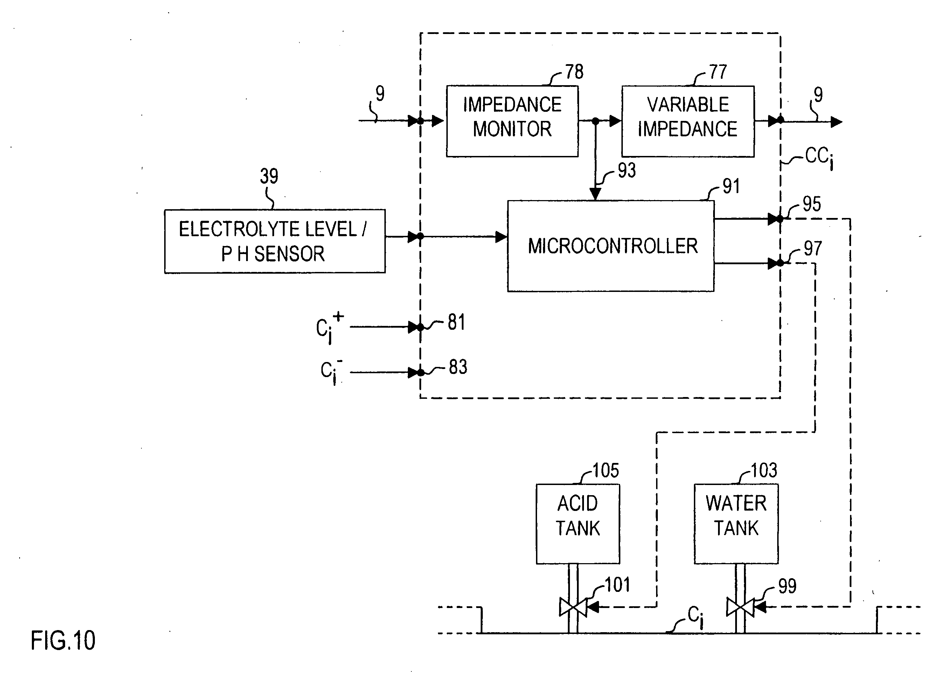

Figure 10 schematically shows one of the battery cell control devices CCᵢ shown in Figure 9. Each cell controlling device CCᵢ is used to control the topping up of acid and water in the respective battery cell Cᵢ, in response to an appropriate control signal received from the central battery control system 80. As in the first embodiments, each cell control device CCᵢ is powered by the cell which it is to control, as represented by inputs Cᵢ⁺ and Cᵢ⁻ applied to input power terminals 81 and 83 respectively. In this embodiment, each cell control device CCᵢ is arranged to receive messages from the central battery control system (not shown), but not to transmit messages back. Therefore only a single wire communication link 9 is required in this embodiment. In operation, the variation in the output impedance of cell control device CCᵢ₋₁ is detected by the impedance monitor 78 from which the up-link message data is regenerated. In this embodiment, the micro-controller 91 is not connected on-line. In other words, the regenerated up-link message data is not decoded and then regenerated by the microcontroller 91 for onward transmission. Instead, the up-link message data regenerated by the impedance monitor 78 is directly used to vary the impedance of the variable impedance device 77 so that the up-link message data is transmitted onto the next cell control device CCᵢ₊₁. The microcontroller 91 monitors the received messages via connection 93 and outputs appropriate control signals to output terminals 95 and 97 when the received signals are directed to it. The control signals output to terminals 95 and 97 are used to control the position of valves 99 and 101 respectively, so as to control the amount of water and acid to be added to the battery cell Cᵢ from the water tank 103 and the acid tank 105. The microcontroller 91 determines the amount of water and acid to add with reference to the sensor signals received from the electrolyte level/PH sensor 39. As those skilled in the art will appreciate, the advantage of not having the microcontroller 91 on-line is that the messages are transmitted along the communications link 9 with minimum delay. However, the disadvantages are that the system becomes more prone to error caused by the desynchronisation of the voltage transitions as the messages are transferred from one cell control device to the next and that there is no error correction being performed on the message data transmitted between adjacent cell control devices.

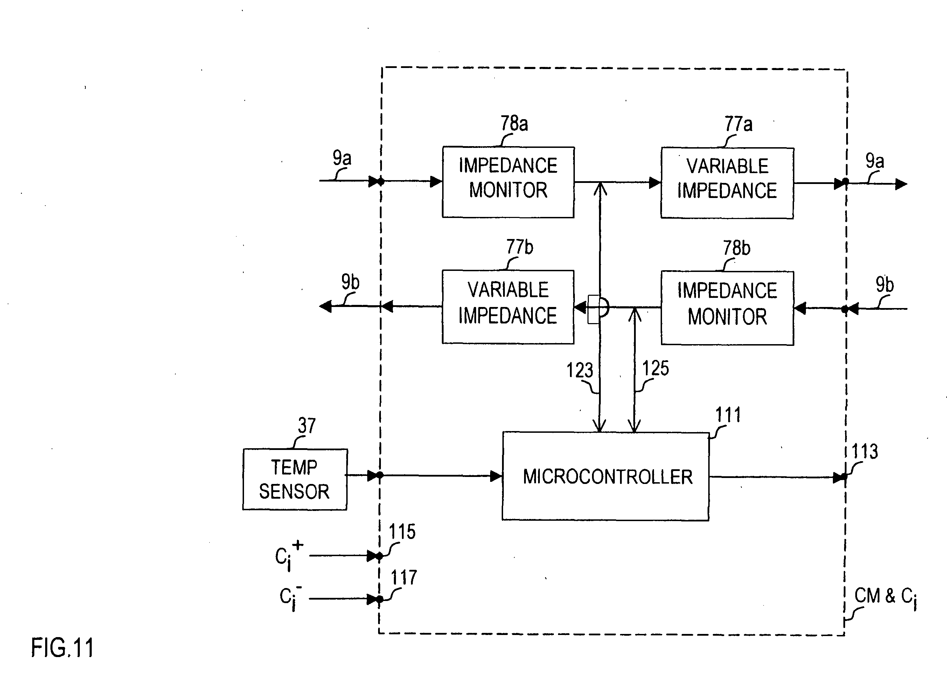

In the above embodiments, a central battery monitoring system or a central battery control system was provided which monitored or controlled the system as a whole. Figure 11 schematically shows a cell monitoring and control device CM&Cᵢ which can be used in a combined battery control and monitoring system in which there is no central battery monitoring and control system and in which each cell monitoring and control device CM&Cᵢ communicates directly with the other cell monitoring and control devices. As in the other embodiments, each cell monitoring and control device CM&Cᵢ is powered by the cell which it is monitoring and controlling, as represented by inputs Cᵢ⁺ and Cᵢ⁻ applied to input power terminals 115 and 117 respectively. As shown in Figure 11, each cell monitoring and control device CM&Cᵢ comprises a microcontroller 111 which receives sensor data from temperature sensor 37 and which outputs control data to output terminal 113 for controlling, for example, a liquid crystal display (not shown) mounted on the respective cell Cᵢ.

In this embodiment, up-link data is regenerated by the impedance monitor 78a and then passed to the variable impedance device 77a for onward transmission to cell monitoring and control device CM&Cᵢ₊₁. Similarly, down-link message data is regenerated by the impedance monitor 78b and passed to the variable impedance device 77b for onward transmission to cell monitoring and control device CM&Cᵢ₋₁. As shown, in this embodiment, the micro-controller 111 is connected off-line to the up-link and the down-link by connections 123 and 125, so that each cell monitoring and control device CM&Cᵢ can receive data from and transmit data to other cell monitoring and control devices.

Various modifications which can be made to the above described embodiments will now be described.

In the first embodiment, a cell monitoring device was used to monitor each cell of the battery. In a cheaper implementation, each cell monitoring device CMᵢ could be used to monitor two or more series connected battery cells Cᵢ.

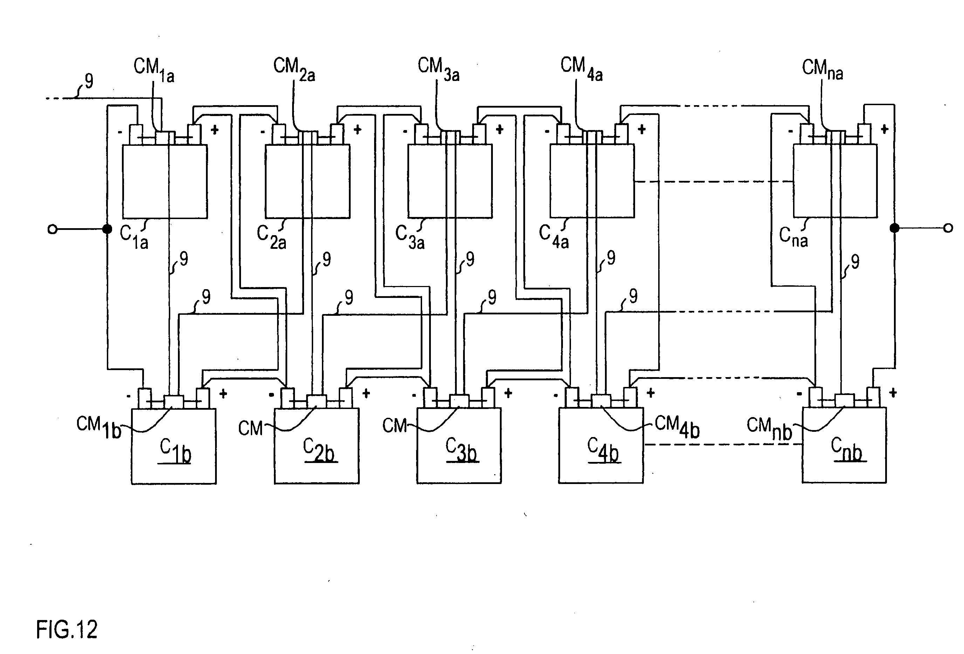

In the embodiments described, the cells are connected in series. It is possible to connect the battery cells Cᵢ in a series-parallel or ladder configuration. Figure 12 shows such an interconnection of battery cells, in which cell Cᵢₐ is connected in parallel with cell C_{ib} and the parallel combinations Cᵢₐ and C_{ib} are connected in series for i = 1 to n. In the configuration shown in Figure 12, a single cell monitoring device CMᵢ is provided for monitoring each of the battery cells and the communication link 9 connects CMᵢₐ to CM_{ib} and CM_{ib} to CMᵢ₊₁ₐ etc. Alternatively, a single cell monitoring device could be used to monitor each parallel combination of battery cells Cᵢₐ and C_{ib}. Additionally, more than two battery cells can be connected in parallel.

In the above embodiments, the central battery monitoring and/or control system was provided at the zero volt reference voltage end of the communication link 9. Alternatively, the central battery monitoring and/or control system could be connected at the high reference voltage end of the communication link 9. Alternatively still, the central battery monitoring and/or control system could be connected at both ends, thereby forming a circular communications path in which messages are transmitted to and received from the battery monitoring/controlling system in one direction through the cell monitoring/controlling devices. Therefore, each cell monitoring/controlling device only needs either an up-link or a down-link, depending on whether the messages are transmitted up or down the communication link 9.

In the above described embodiments, the communication link 9 comprised either one or two wires. As those skilled in the art will appreciate, the communication link 9 may comprise any number of wires along which data can be transmitted in parallel.

In the above embodiments, a separate central battery monitoring system or a central battery control system was provided. In an alternative embodiment, a combined battery monitoring and control system could be used to both monitor and control the battery.

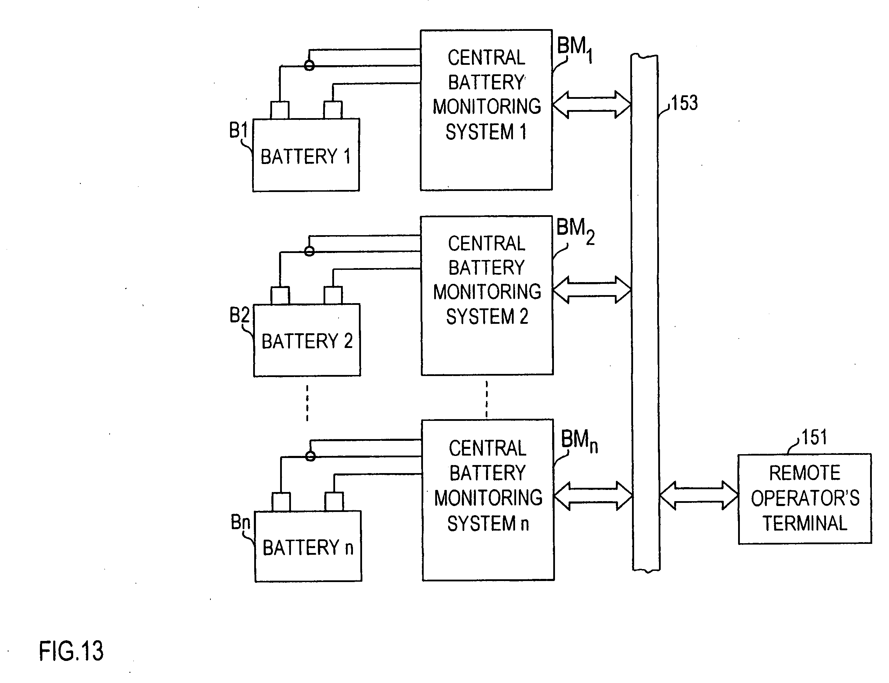

In the above described embodiments, a single battery comprising a plurality of battery cells, is monitored and/or controlled by a central battery monitoring and/or controlling system. Figure 13 shows an alternative embodiment where a plurality of batteries Bᵢ are provided, and wherein each battery Bᵢ is monitored by its own central battery monitoring system BMᵢ which communicates with a remote operator's terminal 151 via a data bus 153. The data bus 153 may be a proprietary data link or can be the public telephone exchange. In operation, each of the central battery monitoring systems BMᵢ monitors the respective battery Bᵢ and reports its status back to the remote operator's terminal 151, where the condition of each of the batteries is monitored by a human operator. A similar system could also be provided for controlling, or for monitoring and controlling a plurality of batteries.

In the above, embodiments, the cell signalling devices are connected in series in a daisy chain configuration, with the position of each cell signalling device in the series communication link corresponding with the position of the cell or cells which are to power the cell signalling device in the series connection of battery cells. This is not essential. The cell signalling devices can be connected in any arbitrary series configuration relative to the series connection of battery cells. This is because the MOSFET switches Q₁ and Q₂ operate in the same manner irrespective of the voltage loading applied across its drain and source electrodes. However, in this case, the values of the resistors Rₐ to R_{f} in each cell monitoring/control device will be different and will be chosen so as to provide the necessary voltage division having regard to the difference in voltage between adjacent cell monitoring devices in the communications link.

The present invention is not limited by the exemplary embodiments described above, and various other modifications and embodiments will be apparent to those skilled in the art.

## Claims

1. A signalling system for use with n series connected battery cells (Cₗ) comprising :
(a) signalling devices (CMₗ₋₁, CMₗ, CMₗ₊₁), each signalling device being associated with are or more of a said n battery cells (Cₗ),
(b) each signalling device (CMᵢ) being provided with cell-monitoring sensors (35,37,39) to monitor or to control the status of the associated battery cell (Cₗ) and being further provided with a wire communication link (9; 9a or 9b) to a central battery monitoring/control system (3), the communication link (9; 9a or 9b) serving for transmitting either signals from the central battery monitoring/control system (3) or cell-status signals indicative of the sensor data,
(c) the signalling devices (CMᵢ₋₁, CMᵢ, CMᵢ₊₁) being electrically connected in series in such a manner that there is a wire communication link (9a or 9b) between the central battery monitoring/control system (3) and the first signalling device (CM₁) in the series and further to each of the subsequent signaling devices in turn
(d) each signalling device (CMₗ) having its own cell indentification address so as to allow the signals from the central battery monitoring/control system (3) to be directed to a specific signalling device (CMₗ) and to allow the central battery monitoring/control system (3) to identify the source of received cell-status signals from the signalling devices (CMₗ₋₁, CMₗ, CMₗ₊₁),
(e) each signalling device (CMₗ) comprising a DC to DC converter (57) the input of which is to be connected to the positive terminal (Cₗ⁺) and the negative terminal (Cₗ⁻) of the respective battery cell (Cₗ) and which generates a third voltage (V_{cc}ⁱ) for powering the respective signalling device (CMₗ)
(f) wherein each signalling device (CMᵢ) further comprises:
- a microcontroller (31) which receives said signals from the central battery monitoring/control system (3) or said detected cell-status signals from said sensors (35,37,39) and converts them into corresponding digital signals;
- a potential divider (41 or 47) being associated with a comparator (43 or 49),
- and an output block (45 or 51),
(g) wherein the microcontroller (31) of a signalling device (CM_{I}) is adapted to receive a signal from an adjacent signalling device (CMₗ₋₁ or CMₗ₊₁) said via the wire connection (9a or 9b) through the potential divider (41 or 47) and comparator (43 or 49) and is further adapted to, where appropriate, transmit via the output block (45 or 51), a corresponding digital signal to the next adjacent signalling device (CMᵢ₊₁ or CMₗ₋₁),
(h) wherein the output block (45 or 51) comprises an electronic switch (Q₁ⁱ or Q₂ⁱ) having an input, an output and a control input, the microcontroller (31) being connected to the control input so that the electronic switch (O₁ⁱ or Q₂ⁱ) is either turned on or switched off in dependence on the digital signal from the microcontroller (31),
(i) wherein in one direction the electronic switch (Q₁^{l}) of the output block (45) of the signalling device (CMᵢ) is connected at its output by said wire connection (9a) to the potential divider (41) at the input of the next adjacent signalling device (CMₗ₊₁) and is to be connected at its input to the negative terminal (Cₗ⁻) of the cells (Cₗ) associated with said one signalling device (CMₗ), or wherein in the other direction the electronic switch (Q₂^{l}) of the output block (51) of the signalling device (CMᵢ) is connected at its output by said wire connection (9b) to the potential divider (47) at the input of the next adjacent signalling device (CMᵢ₋₁) and at its input to said third voltage (V_{cc}^{l}) generated by the respective DC to DC converter (57),
(j) wherein in said one direction said one signalling device (CM_{I}) is adapted to receive signals via the potential divider (41), which is connected at a first end to the wire connection (9a) from the previous adjacent signalling device (CMᵢ₋₁) and at a second end to said third voltage (V_{cc}^{l}) generated by said DC to DC converter (57), the potential divider (41) being adapted to deliver the divided potential to one input of the comparator (43), which is provided at its other input with a first reference voltage (V^{l}_{ref1}) chosen to lie between the voltage levels which are applied at said one input of the comparator (43) when the electronic switch (Q₁^{l-1}) of the output block (45) of the previous adjacent signalling device (CMᵢ₋₁) is switched off or when it is turned on, whereby the output of the comparator (43) is connected to a first input of the microcontroller (31).
(k) or wherein in the other direction said signalling device (CMₗ) is adapted to receive signals via its potential divider (47) which is connected at a first end to the wire connection (9b) from the previous adjacent signalling device (CMᵢ₊₁) and is to be connected at a second end to the negative terminal (Cᵢ⁻) of the cell (Cᵢ) associated with said one signalling device (CMₗ), the potential divider (47) being adapted to deliver the divided potential to one input of the comparator (49), which is provided at its other input with a second reference voltage (Vⁱ_{ref2}) chosen to lie between the voltage levels which are applied at said one input of the comparator (49) when the electronic switch (Q₂ⁱ⁺¹) of the output block (51) of the adjacent previous signalling device (CMᵢ₊₁) is switched off or when it is turned on, whereby the output of the comparator (49) is connected to a second input of the microcontroller (31).

2. A signalling system for use with n series connected battery cells (Cₗ) comprising:
(a) signalling devices (CMᵢ₋₁, CMᵢ, CMᵢ₊₁), each signalling device being associated with one or more of said n battery cells (Cᵢ),
(b) each signalling device (CMᵢ) being provided with cell-monitoring sensors (35,37,39) to monitor or control the the status of the associated battery cell (Cₗ) and being further provided with a single-wire communication link (9) to a central battery monitoring/control system (3), the communication link (9) serving for transmitting either signales from the central battery monitoring/control system (3) or cell-status signals indicative of the sensor data,
(c) the signalling devices (CMᵢ₋₁, CMᵢ, CMᵢ₊₁) being electrically connected in series in such a manner that there is a wire communication link (9) in an uplink direction from the central battery monitoring/control system (3) via the first signalling device (CM₁) in the series to each of the subsequent signalling devices in turn and a communication link (9) in a downlink direction from the last signalling device (CMₙ) in the series back through each of the signalling devices (CMᵢ₊₁, CMᵢ, CMᵢ₋₁) in the series to the central monitoring/control system (3),
(d) each signalling device (CMᵢ) having its own cell identification or address so as to allow the signals from the central battery monitoring/control system (3) to be directed to a specific signalling device (CMᵢ) and to allow the central battery monitoring/control system (3) to identify the source of received cell-status signals from the signalling devices (CMᵢ₋₁, CMᵢ, CMᵢ₊₁),
(e) each signalling device (CMᵢ) comprising a DC to DC converter (57) the input of which is to be connected to the positive terminal (Cᵢ⁺) and the negative terminal (Cₗ⁻) of the respective battery cell (Cₗ) and which generates a third voltage (V_{cc}^{l}) for powering the respective signalling device (CMₗ),
(f) wherein each signalling device (CMᵢ) further comprises:
- a microcontroller (31) which receives said signals from the central battery monitoring/control system (3) or said detected cell-status signals from said sensors (35,37,39) and converts them into corresponding digital signals,
- a first and second potential divider (41,47) being associated with a first and second comparator (43,49), respectively,
- and a first and second output block (45,51),
(g) wherein the microcontroller (31) of a signalling device (CMₗ) is adapted to receive a signal from an adjacent signalling device (CMᵢ₋₁ or CMᵢ₊₁) in the uplink direction via a wire connection (9) through the first potential divider (41) and first comparator (43) and in the downlink direction via a wire connection (9) through the second potential divider (47) and second comparator (49), and is further adapted to, where appropriate, transmit via the first or second output block (45,51), respectively, a corresponding digital signal to the next adjacent signalling device (CMᵢ₊₁ or CMᵢ₋₁).
(h) wherein each output block (45,51) comprises an electronic switch (Q₁ⁱ, Q₂ⁱ) having an input, an output and a control input, the microcontroller (31) being connected to the control input so that the electronic switch (Q₁ⁱ, Q₂ⁱ) is either turned on or switched off in dependence on the digital signal from the microcontroller (31),
(i) wherein in the uplink direction the electronic switch (Q₁ⁱ) of the first output block (45) of one signalling device (CMᵢ) is connected at its output by said wire connection (9) to the first potential divider (41) at the input of the adjacent uplink signalling device (CMᵢ₊₁) and is to be connected at its input to the negative terminal (Cₗ⁻) of the cell (Cₗ) associated with said one signalling device (CMₗ), whereas in the downlink direction the electronic switch (Q₂ⁱ) of the second output block (51) of said one signalling device (CMᵢ) is connected at its output by said wire connection (9) to the second potential divider (47) at the input of the adjacent downlink signalling device (CMᵢ₋₁) and at its input to said third voltage (V_{cc}ⁱ) generated by the respective DC to DC converter (57),
(j) wherein in the uplink direction said one signalling device (CMᵢ) is adapted to receive signals via its first potential divider (41), which is connected at a first end to the wire connection (9) from the adjacent downlink signalling device (CMᵢ₋₁) and at a second end to said third voltage (V_{cc}ⁱ) generated by said DC to DC converter (57), the first potential divider (41) being adapted to deliver the divided potential to one input of the first comparator (43), which is provided at its other input with a first reference voltage (Vⁱ_{ref1}) chosen to lie between the voltage levels which are applied at said one input of the first comparator (43) when the electronic switch (Q₁ⁱ⁻¹) of the first output block (45) of the adjacent downlink signalling device (CMᵢ₋₁) is switched off or when it is turned on, whereby the output of the first comparator (43) is connected to a first input of the microcontroller (31),
(k) wherein in the downlink direction said one signalling device (CMᵢ) is adapted to receive signals via its second potential divider (47) which is connected at a first end to the wire connection (9) from the adjacent uplink signalling device (CMᵢ₊₁) and is to be connected at a second end to the negative terminal (Cᵢ⁻) of the cell (Cᵢ) associated with said one signalling device (CMᵢ), the second potential divider (47) being adapted to deliver the divided potential to one input of the second comparator (49), which is provided at its other input with a second reference voltage (Vⁱ_{ref2}) chosen to lie between the voltage levels which are applied at said one input of the second comparator (49) when the electronic switch (Q₂ⁱ⁺¹) of the second output block (51) of the adjacent uplink signalling device (CMᵢ₊₁) is switched off or when it is turned on, whereby the output of the second comparator (49) is connected to a second input of the microcontroller (31),
(l) and wherein the signalling system is arranged in such a manner that communications between adjacent signalling devices can occur in one direction only at any given time in that in case of an uplink communication the electronic switch (Q₂ⁱ⁺¹) of the second output block (51) of the adjacent uplink signalling device (CMᵢ₊₁) is switched off so that it does not affect the operation of the first potential divider (41) of the adjacent uplink signalling device (CMᵢ₊₁) and in case of a downlink communication the electronic switch (Q₁ⁱ⁻¹) of the first output block (45) of the adjacent downlink signalling device (CMᵢ₋₁) is switched off so that messages and signals pass via the second potential divider (49) and the second comparator (47) of the adjacent downlink signalling device (CMₗ₋₁) into the microcontroller (31) of the adjacent downlink signalling device (CMₗ₋₁).

3. A signalling system for use with n series connected battery cells (C_{I}) comprising :
(a) signalling devices (CMᵢ₋₁, CMᵢ, CMᵢ₊₁), each signalling device being associated with one or more of said n battery cells (Cᵢ),
(b) each signalling device (CMᵢ) being provided with cell-monitoring sensors (35,37,39) to monitor or to contol the status of the associated battery cell (Cₗ) and being further provided with a two-wire communication link (9; 9a,9b) to a central battery monitoring/control system (3), the communication link (9; 9a,9b) serving for transmitting either signals from the central battery monitoring/control system (3) or cell-status signals indicative of the sensor data,
(c) the signalling devices (CMᵢ₋₁, CMᵢ, CMᵢ₊₁) being electrically connected in series in such a manner that there is a wire communication link (9a) in an uplink direction from the central battery monitoring/control system (3) via the first signalling device (CM₁) in the series to each of the subsequent signalling devices in turn and a communication link (9b) in a downlink direction from the last signalling device (CMₙ) in the series back through each of the signalling devices (CMᵢ₊₁, CMᵢ, CMᵢ₋₁) in the series to the central monitoring/control system (3),
(d) each signalling device (CMᵢ) having its own cell identification or address so as to allow the signals from the central battery monitoring/control system (3) to be directed to a specific signalling device (CMᵢ) and to allow the central battery monitoring/control system (3) to identify the source of received cell-status signals from the signalling devices (CMᵢ₋₁, CMᵢ, CMᵢ₊₁),
(e) each signalling device (CMᵢ) comprising a DC to DC converter (57) the input of which is to be connected to the positive terminal (Cᵢ⁺) and the negative terminal (Cᵢ⁻) of the respective battery cell (Cᵢ) and which generates a third voltage (V_{cc}ⁱ) for powering the respective signalling device (CMᵢ),
(f) wherein each signalling device (CMᵢ) further comprises :
- a microcontroller (31) which receives said signals from the central battery monitoring/control system (3) or said detected cell-status signals from said sensors (35,37,39) and converts them into corresponding digital signals,
- a first and second potential divider (41,47) being associated with a first and second comparator (43,49), respectively,
- and a first and second output block (45,51),
(g) wherein the microcontroller (31) of a signalling device (CMₗ) is adapted to receive a signal from an adjacent signalling device (CMᵢ₋₁ or CMᵢ₊₁) in the uplink direction via a first wire connection (9a) through the first potential divider (41) and first comparator (43) and in the downlink direction via a second wire connection (9b) through the second potential divider (47) and second comparator (49), and is further adapted to, where appropriate, transmit via the first or second output block (45,51), respectively, a corresponding digital signal to the next adjacent signalling device (CMᵢ₊₁ or CMᵢ₋₁),
(h) wherein each output block (45,51) comprises an electronic switch (Q₁ⁱ, Q₂ⁱ) having an input, an output and a control input, the microcontroller (31) being connected to the control input so that the electronic switch (Q₁ⁱ, Q₂ⁱ) is either turned on or switched off in dependence on the digital signal from the microcontroller (31),
(i) wherein in the uplink direction the electronic switch (Q₁ⁱ) of the first output block (45) of one signalling device (CMᵢ) is connected at its output by said first wire connection (9a) to the first potential divider (41) at the input of the adjacent uplink signalling device (CMᵢ₊₁) and is to be connected at its input to the negative terminal (Cᵢ⁻) of the cell (Cᵢ) associated with said one signaling device (CMᵢ), whereas in the downlink direction the electronic switch (Q₂ⁱ) of the second output block (51) of said one signalling device (CMᵢ) is connected at its output by said second wire connection (9b) to the second potential divider (47) at the input of the adjacent downlink signalling device (CMᵢ₋₁) and at its input to said third voltage (V_{cc}ⁱ) generated by the respective DC to DC converter (57),
(j) wherein in the uplink direction said one signalling device (CMᵢ) is adapted to receive signals via its first potential divider (41), which is connected at a first end to the wire connection (9a) from the adjacent downlink signalling device (CM_{¡-1}) and at a second end to said third voltage (V_{cc}ⁱ) generated by said DC to DC converter (57), the first potential divider (41) being adapted to deliver the divided potential to one input of the first comparator (43), which is provided at its other input with a first reference voltage (Vⁱ_{ref1}) chosen to lie between the voltage levels which are applied at said one input of the first comparator (43) when the electronic switch (Q₁ⁱ⁻¹) of the first output block (45) of the adjacent downlink signalling device (CMᵢ₋₁) is switched off or when it is turned on, whereby the output of the first comparator (43) is connected to a first input of the microcontroller (31),
(k) and wherein in the downlink direction said one signalling device (CMᵢ) is adapted to receive signals via its second potential divider (47) which is connected at a first end to the second wire connection (9b) from the adjacent uplink signalling device (CMᵢ₊₁) and is to be connected at a second end to the negative terminal (Cᵢ⁻) of the cell (Cᵢ) associated with said one signalling device (CMᵢ), the second potential divider (47) being adapted to deliver the divided potential to one input of the second comparator (49), which is provided at its other input with a second reference voltage (Vⁱ_{ref2}) chosen to lie between the voltage levels which are applied at said one input of the second comparator (49) when the electronic switch (Q₂^{l+1}) of the second output block (51) of the adjacent uplink signalling device (CMᵢ₊₁) is switched off or when it is turned on, whereby the output of the second comparator (49) is connected to a second input of the microcontroller (31).

4. A signalling system according to any of claims 1 to 3, wherein each microcontroller is arranged
(i) to receive communications from said communication link ;
(ii) to determine if the received communication is for itself or for onward transmission; and
(iii) if it is for onward transmission to resynchronize the received communication and to output the resynchronized communication for onward transmission.

5. A battery comprising series connected battery cells, and a signalling system according to any of the preceding claims.

## Patentansprüche

1. Eine Meldeanlage zur Verwendung mit n in Reihe geschalteten Batteriezellen (Cᵢ), umfassend:
(a) Signaleinrichtungen (CMᵢ₋₁, CMᵢ, CMᵢ₊₁), die jeweils mit einer oder mehreren der n Batteriezellen (Cᵢ) verbunden sind,
(b) jede der Signaleinrichtungen (CMᵢ) ist mit Zell-Überwachungssensoren (35,37,39) ausgestattet, um den Zustand der jeweiligen Batteriezelle (Cᵢ) zu überwachen, und desweiteren mit einer Drahtverbindung (9; 9a; 9b) zu einem zentralen Batterieüberwachungs- und -steuersystem (3) ausgestattet, wobei die Drahtverbindung (9; 9a oder 9b) entweder zur Signalübertragung von dem zentralen Batterieüberwachungs- und -steuersystem (3) oder zur Übertragung von Sensordaten anzeigenden Zustandssignalen der Batteriezelle dient,
(c) die Signaleinrichtungen (CMᵢ₋₁, CMᵢ, CMᵢ₊₁) sind in einer Reihenschaltung derart miteinander verbunden, dass eine Drahtverbindung (9a oder 9b) zwischen der zentralen Batterieüberwachungs- und -steuersystem (3) und der ersten Signaleinrichtung (CM₁) in Reihe geschaltet ist und wiederum mit jedem der nachfolgenden Signaleinrichtungen verbunden ist,
(d) jedes der Signaleinrichtungen (CMᵢ) weist eine eigene Zellenidentifikationsadresse auf, damit die Übertragung der Signale von dem zentralen Batterieüberwachungs- und -steuersystem (3) in Richtung einer bestimmten Signaleinrichtung (CMᵢ) ermöglicht wird und damit dem zentralen Batterieüberwachungs- und -steuersystem (3) die Identifizierung der Quelle der empfangenen Batteriezellenzustände aus den Signaleinrichtungen (CMᵢ₋₁, CMᵢ, CMᵢ₊₁) ermöglicht wird,
(e) jedes der Signaleinrichtungen (CMᵢ) umfasst einen Gleichspannungswandler (57), dessen Eingang mit dem positiven Terminal (Cᵢ⁺) und dem negativen Terminal (Cᵢ⁻) der entsprechenden Batteriezelle (Cᵢ) verbunden wird und eine dritte Spannung (V_{cc}ⁱ) generiert, um die entsprechende Signaleinrichtung (CMᵢ) zu versorgen,
(f) wobei jedes der Signaleinrichtungen (CMᵢ) weiterhin umfasst:
- einen Mikrosteuerbaustein (31), welcher die genannten Signale vom zentralen Batterieüberwachungs- und -steuersystem (3) oder den detektierten Zustand des Batteriezellensignals von den genannten Sensoren (35,37,39) empfängt und diese in die entsprechenden digitalen Signale umwandelt,
- einen Spannungsteiler (41 oder 47), der mit einem Komparator (43 oder 49) verbunden ist,
- und ein Ausgangsblock (45 oder 51),
(g) wobei der Mikrosteuerbaustein (31) einer Signaleinrichtung (CMᵢ) geeignet ist, ein Signal von einer benachbarten Signaleinrichtung (CMᵢ₋₁ oder CMᵢ₊₁) über die Drahtverbindung (9a oder 9b) durch den Spannungsteiler (41 oder 47) und Komparator (43 oder 49) zu empfangen und weiterhin geeignet ist, um über den Ausgangsblock (45 oder 51) ein entsprechendes digitales Signal zu der nächsten benachbarten Signaleinrichtung (CMᵢ₊₁ oder CMᵢ₋₁) zu übertragen, wo dies angemessen ist,
(h) wobei der Ausgangsblock (45 oder 51) einen elektronischen Schalter (Q₁ oder Q₂) mit einem Eingang, einem Ausgang und einem Steuereingang umfasst, und wobei der Mikrosteuerbaustein (31) derart an den Steuereingang angeschlossen ist, dass der elektronische Schalter (Q₁ oder Q₂) abhängig von dem digitalen Signal des Mikrosteuerbaustein (31) entweder eingeschaltet oder ausgeschaltet wird,
(i) wobei in einer Richtung der elektronische Schalter (Q₁ⁱ) des Ausgangsblocks (45) der Signaleinrichtung (CMᵢ) an seinem Ausgang mittels der genannten Drahtverbindungen (9a) mit dem Spannungsteiler (41) an dem Eingang der nächsten benachbarten Signaleinrichtung (CMᵢ₊₁) verbunden ist und an seinem Eingang mit dem negativen Terminal (Cᵢ⁻) der mit der einen genannten Signaleinrichtung (CMᵢ) assoziierten Batteriezelle (Cᵢ) verbunden ist,
oder wobei in der anderen Richtung der elektronische Schalter (Q₂ⁱ) des Ausgangsblocks (51) der Signaleinrichtung (CMᵢ) an seinem Ausgang mittels der genannten Drahtverbindung (9b) mit dem Spannungsteiler (47) an dem Eingang der nächsten benachbarten Signaleinrichtung (CMᵢ₋₁) angeschlossen ist und an seinem Eingang die dritte von dem entsprechenden Gleichspannungswandler (57) generierten Spannung (V_{cc}ⁱ) angelegt ist,
(j) wobei in der besagten einen Richtung eine der genannten Signaleinrichtungen (CMᵢ) ausgelegt ist, um Signale über den Spannungsteiler (41) zu empfangen, welcher mit einem ersten Ende mit der Drahtverbindung (9a) der vorherigen benachbarten Signaleinrichtung (CMᵢ₋₁) und an einem zweiten Ende an der dritten von dem entsprechenden Gleichspannungswandler (57) generierten Spannung (V_{cc}ⁱ) angeschlossen ist, der Spannungsteiler (41) geeignet ist, die geteilte Spannung zu einem Eingang des Komparators (43) zu liefern, welcher an dessen anderen Eingang eine erste Referenzspannung (Vⁱ_{ref1}) angelegt ist, die ausgewählt ist, zwischen den Spannungspegeln zu liegen, welche an dem genannten Eingang des Komparators (43) angelegt sind, falls der elektronische Schalter (Q₁ⁱ⁻¹) des Ausgangsblocks (45) der vorherigen benachbarten Signaleinrichtung (CMᵢ₋₁) ausgeschaltet oder eingeschaltet ist, wobei der Ausgang des Komparators (43) mit einem ersten Eingang des Mikrosteuerbausteins (31) verbunden ist,
(k) oder wobei in der anderen Richtung die genannte Signaleinrichtung (CMᵢ) geeignet ist, Signale über ihren Spannungsteiler (47) zu empfangen, welcher an einem ersten Ende mit der Drahtverbindung (9b) der vorherigen benachbarten Signaleinrichtung (CMᵢ₊₁) verbunden ist und an einem zweiten Ende mit dem negativen Terminal (Cᵢ⁻) der mit der einen genannten Signaleinrichtung (CMᵢ) assoziierten Zelle (Cᵢ) verbunden ist, wobei der Spannungsteiler (47) geeignet ist, die geteilte Spannung an einen Eingang des Komparators (49) zu liefern, an dessen anderem Eingang eine zweite Referenzspannung (Vⁱ_{ref2}) angelegt werden, die zwischen den Spannungspegeln, die an dem genannten einen Eingang des Komparators (49) liegen, falls der elektronische Schalter (Q₂ⁱ⁺¹) des Ausgangsblocks (51) der vorherigen benachbarten Signaleinrichtung (CMᵢ₊₁) ausgeschaltet oder eingeschaltet ist, wobei der Ausgang des Komparators (49) mit einem zweiten Eingang des Mikrosteuerbausteins (31) verbunden ist.

2. Eine Meldeanlage zur Verwendung mit n in Reihe geschalteten Batteriezellen (Cᵢ), umfassend:
(a) Signaleinrichtungen (CMᵢ₋₁, CMᵢ, CMᵢ₊₁), die jeweils mit einer oder mehreren der n Batteriezellen (Cᵢ) verbunden sind,
(b) jedes der Signaleinrichtungen (CMᵢ) ist mit Zell-Überwachungssensoren (35,37,39) ausgestattet, um den Zustand der jeweiligen Batteriezelle (Cᵢ) zu überwachen, und desweiteren mit einer eindrähtigen Drahtverbindung (9) zu einem zentralen Batterieüberwachungs- und -steuersystem (3) ausgestattet, wobei die Drahtverbindung (9) entweder zur Signalübertragung von dem zentralen Batterieüberwachungs- und - steuersystem (3) oder zur Übertragung von die Sensordaten anzeigenden Zustandssignalen der Batteriezelle dient,
(c) die Signaleinrichtungen (CMᵢ₋₁, CMᵢ, CMᵢ₊₁) sind in einer Reihenschaltung derart miteinander verbunden, dass eine Drahtverbindung (9) in einer Uplink-Verbindung von dem zentralen Batterieüberwachungs- und -steuersystem (3) über die erste Signaleinrichtung (CM₁) in Reihe geschaltet ist und mit jedem der nachfolgenden Signaleinrichtungen verbunden ist und eine Drahtverbindung (9) in einer Downlink-Verbindung von der letzten Signaleinrichtung (CMₙ) durch jedes der Signaleinrichtungen (CMᵢ₋₁, CMᵢ, CMᵢ₊₁) seriell zu dem zentralen Batterieüberwachungs- und -steuersystem (3) rückverbunden ist,
(d) jedes der Signaleinrichtungen (CMᵢ) weist eine eigene Zellenidentifikation oder Adresse auf, damit die Übertragung der Signale von dem zentralen Batterieüberwachungs- und -steuersystem (3) in Richtung einer bestimmten Signaleinrichtung (CMᵢ) ermöglicht wird und damit dem zentralen Batterieüberwachungs- und -steuersystem (3) die Identifizierung der Quelle der empfangenen Batteriezellenzustände aus den Signaleinrichtungen (CMᵢ₋₁, CMᵢ, CMᵢ₊₁) ermöglicht wird,
(e) jedes der Signaleinrichtungen (CMᵢ) umfasst einen Gleichspannungswandler (57), dessen Eingang mit dem positiven Terminal (Cᵢ⁺) und dem negativen Terminal (Cᵢ⁻) der entsprechenden Batteriezelle (Cᵢ) verbunden wird und eine dritte Spannung (V_{cc}ⁱ) generiert, um die entsprechende Signaleinrichtung (CMᵢ) zu versorgen,
(f) wobei jedes der Signaleinrichtungen (CMᵢ) weiterhin umfasst:
- einen Mikrosteuerbaustein (31), welcher die genannten Signale vom zentralen Batterieüberwachungs- und -steuersystem (3) oder den detektierten Zustand des Batteriezellensignals von den genannten Sensoren (35,37,39) empfängt und diese in die entsprechenden digitalen Signale umwandelt,
- einen ersten und einen zweiten Spannungsteiler (41, 47), die entsprechend mit einem Komparator (43, 49) verbunden sind,
- und ein erster und ein zweiter Ausgangsblock (45, 51),
(g) wobei der Mikrosteuerbaustein (31) einer Signaleinrichtung (CMᵢ) geeignet ist, ein Signal von einer benachbarten Signaleinrichtung (CMᵢ₋₁ oder CMᵢ₊₁) in einer Uplink-Verbindung über eine Drahtverbindung (9) durch den ersten Spannungsteiler (41) und den ersten Komparator (43) und in der Downlink-Verbindung über eine Drahtverbindung (9) durch den zweiten Spannungsteiler (47) und den zweiten Komparator (49) zu empfangen und weiterhin geeignet ist, um über den entsprechenden ersten oder zweiten Ausgangsblock (45, 51) ein entsprechendes digitales Signal zu der nächsten benachbarten Signaleinrichtung (CMᵢ₊₁ oder CMᵢ₋₁) zu übertragen, wo dies angemessen ist,
(h) wobei jedes der Ausgangsblöcke (45, 51) einen elektronischen Schalter (Q₁, Q₂) mit einem Eingang, einem Ausgang und einem Steuereingang umfasst, und wobei der Mikrosteuerbaustein (31) derart an den Steuereingang angeschlossen ist, dass der elektronische Schalter (Q₁, Q₂) abhängig von dem digitalen Signal des Mikrosteuerbaustein (31) entweder eingeschaltet oder ausgeschaltet wird,
(i) wobei in einer Uplink-Richtung der elektronische Schalter (Q₁ⁱ) des ersten Ausgangsblocks (45) einer Signaleinrichtung (CMᵢ) an seinem Ausgang mittels der genannten Drahtverbindung (9) mit dem ersten Spannungsteiler (41) an dem Eingang der benachbarten Uplink-Signaleinrichtung (CMᵢ₊₁) verbunden ist und an seinem Eingang mit dem negativen Terminal (Cᵢ⁻) der mit der einen genannten Signaleinrichtung (CMᵢ) assoziierten Batteriezelle (Cᵢ) verbunden ist, wohingegen in der Downlink-Richtung der elektronische Schalter (Q₂ⁱ) des zweiten Ausgangsblocks (51) der genannten einen Signaleinrichtung (CMᵢ) an seinem Ausgang mittels der genannten Drahtverbindung (9) mit dem zweiten Spannungsteiler (47) an dem Eingang der benachbarten Downlink-Signaleinrichtung (CMᵢ₋₁) angeschlossen ist und an seinem Eingang die dritte von dem entsprechenden Gleichspannungswandler (57) generierten Spannung (V_{cc}ⁱ) angelegt ist,
(j) wobei in der Uplink-Richtung eine genannte Signaleinrichtung (CMᵢ) ausgelegt ist, Signale über seinen ersten Spannungsteiler (41) zu empfangen, welcher mit einem ersten Ende mit der Drahtverbindung (9) der benachbarten Signaleinrichtung (CMᵢ₋₁) und an einem zweiten Ende an der dritten von dem entsprechenden Gleichspannungswandler (57) generierten Spannung (V_{cc}ⁱ) angeschlossen ist, der erste Spannungsteiler (41) geeignet ist, die geteilte Spannung zu einem Eingang des ersten Komparators (43) zu liefern, welcher an dessen anderen Eingang eine erste Referenzspannung (Vⁱ_{ref1}) angelegt ist, die ausgewählt ist, zwischen den Spannungspegeln zu liegen, welche an dem genannten Eingang des ersten Komparators (43) angelegt sind, falls der elektronische Schalter (Q₁ⁱ⁻¹) des ersten Ausgangsblocks (45) der benachbarten Downlink-Signaleinrichtung (CMᵢ₋₁) ausgeschaltet oder eingeschaltet ist, wobei der Ausgang des ersten Komparators (43) mit einem ersten Eingang des Mikrosteuerbausteins (31) verbunden ist,
(k) wobei in der Downlink-Richtung die genannte eine Signaleinrichtung (CMᵢ) geeignet ist, Signale über ihren zweiten Spannungsteiler (47) zu empfangen, welcher an einem ersten Ende mit der Drahtverbindung (9) der benachbarten Uplink-Signaleinrichtung (CMᵢ₊₁) verbunden ist und an einem zweiten Ende mit dem negativen Terminal (Cᵢ⁻) der mit der einen genannten Signaleinrichtung (CMᵢ) assoziierten Zelle (Cᵢ) verbunden ist, wobei der zweite Spannungsteiler (47) geeignet ist, die geteilte Spannung zu einem Eingang des zweiten Komparators (49) zu liefern, an dessen anderem Eingang eine zweite Referenzspannung (Vⁱ_{ref2}) angelegt ist, die zwischen den Spannungspegeln, die an dem genannten einen Eingang des zweiten Komparators (49) liegen, falls der elektronische Schalter (Q₂ⁱ⁺¹) des zweiten Ausgangsblocks (51) der benachbarten Uplink-Signaleinrichtung (CMᵢ₊₁) ausgeschaltet oder eingeschaltet ist, wobei der Ausgang des zweiten Komparators (49) mit einem zweiten Eingang des Mikrosteuerbausteins (31) verbunden ist,
(l) und wobei die Meldeanlage derart angeordnet ist, dass die Nachrichten zwischen benachbarten Signaleinrichtungen zu jeder Zeit nur in einer Richtung passieren können, weil im Falle einer Uplink-Verbindung der elektronische Schalter (Q₂ⁱ⁺¹) des zweiten Ausgangsblocks (51) der benachbarten Uplink-Signaleinrichtung (CMᵢ₊₁) ausgeschaltet ist, so dass es die Funktion des ersten Spannungsteilers (41) der benachbarten Uplink-Signaleinrichtung (CMᵢ₊₁) nicht beeinflusst und im Falle einer Downlink-Verbindung der elektronische Schalter (Q₁ⁱ⁻¹) des ersten Ausgangsblocks (45) der benachbarten Downlink-Signaleinrichtung (CMᵢ₋₁) ausgeschaltet ist, so dass Nachrichten und Signale über den zweiten Spannungsteiler (49) und den zweiten Komparator (47) der benachbarten Downlink-Signaleinrichtung (CMᵢ₋₁) in Richtung des Mikrosteuerbausteins (31) des benachbarten Downlink-Signaleinrichtung (CMᵢ₋₁) passieren.

3. Eine Meldeanlage zur Verwendung mit n in Reihe geschalteten Batteriezellen (Cᵢ), umfassend:
(a) Signaleinrichtungen (CMᵢ₋₁, CMᵢ, CMᵢ₊₁), die jeweils mit einem oder mehr der n Batteriezellen (Cᵢ) verbunden sind,
(b) jedes der Signaleinrichtungen (CMᵢ) ist mit einem Zell-Überwachungssensoren (35,37,39) ausgestattet, um den Zustand der jeweiligen Batteriezelle (Cᵢ) zu überwachen, und desweiteren mit einer zweidrähtigen Drahtverbindung (9; 9a oder 9b) zu einem zentralen Batterieüberwachungs- und -steuersystem (3) ausgestattet, wobei die Drahtverbindung (9; 9a oder 9b) entweder zur Signalübertragung von dem zentralen Batterieüberwachungs- und -steuersystem (3) oder zur Übertragung von die Sensordaten anzeigenden Zustandssignalen der Batteriezelle dient,
(c) die Signaleinrichtungen (CMᵢ₋₁, CMᵢ, CMᵢ₊₁) sind in einer Reihenschaltung derart miteinander verbunden, dass eine Drahtverbindung (9a) in einer Uplink-Verbindung von dem zentralen Batterieüberwachungs- und -steuersystem (3) über die erste Signaleinrichtung (CM₁) in Reihe geschaltet ist und mit jedem der nachfolgenden Signaleinrichtungen verbunden und eine Drahtverbindung (9b) in einer Downlink-Verbindung von der letzten Signaleinrichtung (CMₙ) seriell durch jedes der Signaleinrichtungen (CMᵢ₋₁, CMᵢ, CMᵢ₊₁) seriell zu dem zentralen Batterieüberwachungs- und -steuersystem (3) rückverbunden ist,
(d) jedes der Signaleinrichtungen (CMᵢ) weist eine eigene Zellenidentifikation oder Adresse auf, damit die Übertragung der Signale von der zentralen Batterieüberwachungs- und -steuersystem (3) in Richtung einer bestimmten Signaleinrichtung (CMᵢ) ermöglicht wird und damit dem zentralen Batterieüberwachungs- und -steuersystem (3) die Identifizierung der Quelle der empfangenen Batteriezellenzustände aus den Signaleinrichtungen (CMᵢ₋₁, CMᵢ, CMᵢ₊₁) ermöglicht wird,
(e) jedes der Signaleinrichtungen (CMᵢ) umfasst einen Gleichspannungswandler (57), dessen Eingang mit dem positiven Terminal (Cᵢ⁺) und dem negativen Terminal (Cᵢ⁻) der entsprechenden Batteriezelle (Cᵢ) verbunden wird und eine dritte Spannung (V_{cc}ⁱ) generiert, um die entsprechende Signaleinrichtungen (CMᵢ) zu versorgen,
(f) wobei jedes der Signaleinrichtungen (CMᵢ) weiterhin umfasst:
- einen Mikrosteuerbaustein (31), welcher die genannten Signale vom zentralen Batterieüberwachungs- und -steuersystem (3) oder den detektierten Zustand des Batteriezellensignals von den genannten Sensoren (35,37,39) empfängt und diese in die entsprechenden digitalen Signale umwandelt,
- einen ersten und einen zweiten Spannungsteiler (41, 47), die entsprechend mit einem Komparator (43, 49) verbunden sind,
- und ein erster und ein zweiter Ausgangsblock (45, 51),
(g) wobei der Mikrosteuerbaustein (31) einer Signaleinrichtung (CMᵢ) geeignet ist, ein Signal von einer benachbarten Signaleinrichtung (CMᵢ₋₁ oder CMᵢ₊₁) in einer Uplink-Verbindung über eine erste Drahtverbindung (9a) durch den ersten Spannungsteiler (41) und ersten Komparator (43) und in der Downlink-Verbindung über eine zweite Drahtverbindung (9b) durch den zweiten Spannungsteiler (47) und zweiten Komparator (49) zu empfangen und weiterhin geeignet ist, über den entsprechenden ersten oder zweiten Ausgangsblock (45, 51) ein entsprechendes digitales Signal zu der nächsten benachbarten Signaleinrichtung (CMᵢ₊₁ oder CMᵢ₋₁) zu übertragen, wo dies angemessen ist,
(h) wobei jedes der Ausgangsblöcke (45, 51) einen elektronischen Schalter (Q₁, Q₂) mit einem Eingang, einem Ausgang und einem Steuereingang umfasst, und wobei der Mikrosteuerbaustein (31) derart an den Steuereingang angeschlossen ist, dass der elektronische Schalter (Q₁, Q₂) abhängig von dem digitalen Signal des Mikrosteuerbaustein (31) entweder eingeschaltet oder ausgeschaltet wird,
(i) wobei in einer Uplink-Richtung der elektronische Schalter (Q₁ⁱ) des ersten Ausgangsblocks (45) einer Signaleinrichtung (CMᵢ) an seinem Ausgang mittels der genannten ersten Drahtverbindung (9a) mit dem ersten Spannungsteiler (41) an dem Eingang der benachbarten Uplink-Signaleinrichtung (CMᵢ₊₁) verbunden ist und an seinem Eingang mit dem negativen Terminal (Cᵢ⁻) der mit der einen genannten Signaleinrichtung (CMᵢ) assoziierten Batteriezelle (Cᵢ) verbunden ist, wohingegen in der Downlink-Richtung der elektronische Schalter (Q₂ⁱ) des zweiten Ausgangsblocks (51) der genannten einen Signaleinrichtung (CMᵢ) an seinem Ausgang mittels der genannten zweiten Drahtverbindung (9b) mit dem zweiten Spannungsteiler (47) an dem Eingang der benachbarten Downlink-Signaleinrichtung (CMᵢ₋₁) angeschlossen ist und an seinem Eingang die dritte von dem entsprechenden Gleichspannungswandler (57) generierten Spannung (V_{cc}ⁱ) angelegt ist,
(j) wobei in der genannten einen Richtung eine genannte Signaleinrichtung (CMᵢ) ausgelegt ist, um Signale über seinen ersten Spannungsteiler (41) zu empfangen, welcher mit einem ersten Ende mit der Drahtverbindung (9a) der benachbarten Signaleinrichtung (CMᵢ₋₁) und an einem zweiten Ende an der dritten von dem entsprechenden Gleichspannungswandler (57) generierten Spannung (V_{cc}ⁱ) angeschlossen ist, der erste Spannungsteiler (41) geeignet ist, um die geteilte Spannung zu einem Eingang des ersten Komparators (43) zu liefern, welcher an dessen anderen Eingang eine ersten Referenzspannung (Vⁱ_{ref1}) angelegt ist, die ausgewählt ist, zwischen den Spannungspegeln zu liegen, welche an dem genannten Eingang des ersten Komparators (43) angelegt sind, falls der elektronische Schalter (Q₁ⁱ⁻¹) des ersten Ausgangsblocks (45) der benachbarten Downlink-Signaleinrichtung (CMᵢ₋₁) ausgeschaltet oder eingeschaltet ist, wobei der Ausgang des ersten Komparators (43) mit einem ersten Eingang des Mikrosteuerbausteins (31) verbunden ist,
(k) wobei in der Downlink-Richtung die genannte eine Signaleinrichtung (CMᵢ) geeignet ist, Signale über ihren zweiten Spannungsteiler (47) zu empfangen, welcher an einem ersten Ende mit der zweiten Drahtverbindung (9b) der benachbarten Uplink-Signaleinrichtung (CMᵢ₊₁) verbunden ist und an einem zweiten Ende mit dem negativen Terminal (Cᵢ⁻) der mit der einen genannten Signaleinrichtung (CMᵢ) assoziierten Zelle (Cᵢ) verbunden ist, wobei der zweite Spannungsteiler (47) geeignet ist, die geteilte Spannung an einem Eingang des zweiten Komparators (49) zu liefern, an dessen anderem Eingang eine zweite Referenzspannung (Vⁱ_{ref2}) angelegt ist, die zwischen den Spannungspegeln, die an dem genannten einen Eingang des zweiten Komparators (49) liegen, falls der elektronische Schalter (Q₂ⁱ⁺¹) des zweiten Ausgangsblocks (51) der benachbarten Uplink-Signaleinrichtung (CMᵢ₊₁) ausgeschaltet oder eingeschaltet ist, wobei der Ausgang des zweiten Komparators (49) mit einem zweiten Eingang des Mikrosteuerbausteins (31) verbunden ist.

4. Eine Meldeanlage nach einem der Ansprüche 1 bis 3, wobei jedes der Mikrosteuerbausteins (31) angeordnet ist
(i) um Nachrichten von der genannten Nachrichtenverbindung zu empfangen;
(ii) um zu Bestimmen, ob die empfangene Nachricht zum Eigengebrauch oder zur Weiterübertragung geeignet ist; und
(iii) falls es eine Weiterübertragung ist, um die empfangene Nachricht zu resynchronisieren und um die resynchronisierte Nachricht für die Weiterübertragung auszugeben.

5. Eine Batterie, umfassend n in Serie geschalteten Batteriezellen und eine Meldeanlage nach einem der vorhergehenden Ansprüche.

## Revendications

1. Système de signalisation pour une utilisation avec n cellules de batterie reliées en série (Cᵢ) comprenant :
(a) des dispositifs de signalisation (CMᵢ₋₁, CMᵢ, CMᵢ₊₁), chaque dispositif de signalisation étant associé à une ou plusieurs desdites n cellules de batterie (Cᵢ),
(b) chaque dispositif de signalisation (CMᵢ) étant muni de capteurs de contrôle de cellule (35, 37, 39) pour contrôler ou commander l'état de la cellule de batterie associée (Cᵢ) et étant en outre muni d'une liaison de communication filaire (9 ; 9a ou 9b) avec un système central de contrôle / commande de batterie (3), la liaison de communication (9 ; 9a ou 9b) servant à transmettre soit des signaux en provenance du système central de contrôle / commande de batterie (3) soit des signaux d'état de cellule indicatifs des données de capteur,
(c) les dispositifs de signalisation (CMᵢ₋₁, CMᵢ, CMᵢ₊₁) étant électriquement reliés en série de sorte qu'il y ait une liaison de communication filaire (9a ou 9b) entre le système central de contrôle / commande de batterie (3) et le premier dispositif de signalisation (CM₁) dans la série et en outre avec chacun des dispositifs de signalisation suivants à leur tour,
(d) chaque dispositif de signalisation (CMᵢ) ayant sa propre identification de cellule ou adresse de façon à permettre aux signaux en provenance du système central de contrôle / commande de batterie (3) d'être dirigés vers un dispositif de signalisation spécifique (CMᵢ) et pour permettre au système central de contrôle / commande de batterie (3) d'identifier la source de signaux d'état de cellule reçus en provenance des dispositifs de signalisation (CMᵢ₋₁, CMᵢ, CMᵢ₊₁),
(e) chaque dispositif de signalisation (CMᵢ) comprenant un convertisseur continu-continu (57) dont l'entrée est à relier à la borne positive (Cᵢ⁺) et à la borne négative (Cᵢ⁻) de la cellule de batterie respective (Cᵢ) et qui produit une troisième tension (V_{cc}ⁱ) pour alimenter le dispositif de signalisation respectif (CMᵢ),
(f) dans lequel chaque dispositif de signalisation (CMᵢ) comprend en outre :
- une micro-unité de commande (31) qui reçoit lesdits signaux en provenance du système central de contrôle / commande de batterie (3) ou lesdits signaux d'état de cellule détectés en provenance desdits capteurs (35, 37, 39) et les transforme en signaux numériques correspondants,
- un diviseur de potentiel (41 ou 47) étant associé à un comparateur (43 ou 49),
- et un bloc de sortie (45 ou 51),
(g) dans lequel la micro-unité de commande (31) d'un dispositif de signalisation (CMᵢ) est conçue pour recevoir un signal en provenance d'un dispositif de signalisation adjacent (CMᵢ₋₁ ou CMᵢ₊₁) via la connexion filaire (9a ou 9b) par l'intermédiaire du diviseur de potentiel (41 ou 47) et du comparateur (43 ou 49) et est en outre conçue, lorsque cela est nécessaire, pour transmettre via le bloc de sortie (45 ou 51) un signal numérique correspondant au dispositif de signalisation adjacent suivant (CMᵢ₊₁ ou CMᵢ₋₁),
(h) dans lequel le bloc de sortie (45 ou 51) comprend un commutateur électronique (Q₁ⁱ ou Q₂ⁱ) ayant une entrée, une sortie et une entrée de commande, la micro-unité de commande (31) étant reliée à l'entrée de commande de sorte que le commutateur électronique (Q₁ⁱ ou Q₂ⁱ) est soit rendu passant soit rendu bloquant en fonction du signal numérique en provenance de la micro-unité de commande (31),
(i) dans lequel, dans un sens particulier, le commutateur électronique (Q₁ⁱ) du bloc de sortie (45) du dispositif de signalisation (CMᵢ) est relié au niveau de sa sortie par ladite connexion filaire (9a) au diviseur de potentiel (41) au niveau de l'entrée du dispositif de signalisation adjacent suivant (CMᵢ₊₁) et doit être relié au niveau de son entrée à la borne négative (Cᵢ⁻) de la cellule (Cᵢ) associée audit dispositif de signalisation particulier (CMᵢ), ou dans lequel, dans l'autre sens, le commutateur électronique (Q₂ⁱ) du bloc de sortie (51) du dispositif de signalisation (CMᵢ) est relié au niveau de sa sortie par ladite connexion filaire (9b) au diviseur de potentiel (47) au niveau de l'entrée du dispositif de signalisation adjacent suivant (CMᵢ₋₁) et au niveau de son entrée à ladite troisième tension (V_{cc}ⁱ) produite par le convertisseur continu-continu respectif (57),
(j) dans lequel, dans ledit sens particulier, ledit dispositif de signalisation particulier (CMᵢ) est conçu pour recevoir des signaux via le diviseur de potentiel (41), qui est relié au niveau d'une première extrémité à la connexion filaire (9a) à partir du dispositif de signalisation adjacent précédent (CMᵢ₋₁) et au niveau d'une seconde extrémité à ladite troisième tension (V_{cc}ⁱ) produite par ledit convertisseur continu-continu (57), le diviseur de potentiel (41) étant conçu pour délivrer le potentiel divisé à une entrée particulière du comparateur (43), qui est muni au niveau de son autre entrée d'une première tension de référence (Vⁱ_{ref1}) choisie pour se situer entre les niveaux de tension qui sont appliqués au niveau de ladite entrée particulière du comparateur (43) quand le commutateur électronique (Q₁ⁱ⁻¹) du bloc de sortie (45) du dispositif de signalisation adjacent précédent (CMᵢ₋₁) est rendu bloquant ou quand il est rendu passant, de sorte que la sortie du comparateur (43) est reliée à une première entrée de la micro-unité de commande (31),
(k) ou dans lequel, dans l'autre sens, ledit dispositif de signalisation (CMᵢ) est conçu pour recevoir des signaux via son diviseur de potentiel (47) qui est relié au niveau d'une première extrémité à la connexion filaire (9b) à partir du dispositif de signalisation adjacent précédent (CMᵢ₊₁) et doit être relié au niveau d'une seconde extrémité à la borne négative (Cᵢ⁻) de la cellule (Cᵢ) associée audit dispositif de signalisation particulier (CMᵢ), le diviseur de potentiel (47) étant conçu pour délivrer le potentiel divisé à une entrée particulière du comparateur (49), qui est muni au niveau de son autre entrée d'une seconde tension de référence (Vⁱ_{ref2}) choisie pour se situer entre les niveaux de tension qui sont appliqués à ladite entrée particulière du comparateur (49) lorsque le commutateur électronique (Q₂ⁱ⁺¹) du bloc de sortie (51) du dispositif de signalisation adjacent précédent (CMᵢ₊₁) est rendu bloquant ou quand il est rendu passant, de sorte que la sortie du comparateur (49) est reliée à une seconde entrée de la micro-unité de commande (31).

2. Système de signalisation pour une utilisation avec n cellules de batterie reliées en série (Cᵢ) comprenant :
(a) des dispositifs de signalisation (CMᵢ₋₁, CMᵢ, CMᵢ₊₁), chaque dispositif de signalisation étant associé à une ou plusieurs desdites n cellules de batterie (Cᵢ),
(b) chaque dispositif de signalisation (CMᵢ) étant muni de capteurs de contrôle de cellule (35, 37, 39) pour contrôler ou commander l'état de la cellule de batterie associée (Cᵢ) et étant en outre muni d'une liaison de communication à fil unique (9) avec un système central de contrôle / commande de batterie (3), la liaison de communication (9) servant à transmettre soit des signaux en provenance du système central de contrôle / commande de batterie (3) soit des signaux d'état de cellule indicatifs des données de capteur,
(c) les dispositifs de signalisation (CMᵢ₋₁, CMᵢ, CMᵢ₊₁) étant électriquement reliés en série de sorte qu'il y ait une liaison de communication filaire (9) dans un sens de liaison montante à partir du système central de contrôle / commande de batterie (3) via le premier dispositif de signalisation (CM₁) dans la série avec chacun des dispositifs de signalisation suivants à leur tour et une liaison de communication (9) dans un sens de liaison descendante à partir du dernier dispositif de signalisation (CMₙ) dans la série en retour par l'intermédiaire de chacun des dispositifs de signalisation (CMᵢ₊₁, CMᵢ, CMᵢ₋₁) dans la série jusqu'au système central de contrôle / commande (3),
(d) chaque dispositif de signalisation (CMᵢ) ayant sa propre identification de cellule ou adresse de façon à permettre aux signaux en provenance du système central de contrôle / commande de batterie (3) d'être dirigés vers un dispositif de signalisation spécifique (CMᵢ) et pour permettre au système central de contrôle / commande de batterie (3) d'identifier la source de signaux d'état de cellule reçus en provenance des dispositifs de signalisation (CMᵢ₋₁, CMᵢ, CMᵢ₊₁),
(e) chaque dispositif de signalisation (CMᵢ) comprenant un convertisseur continu-continu (57) dont l'entrée doit être reliée à la borne positive (Cᵢ⁺) et à la borne négative (Cᵢ⁻) de la cellule de batterie respective (Cᵢ) et qui produit une troisième tension (V_{cc}ⁱ) pour alimenter le dispositif de signalisation respectif (CMᵢ),
(f) dans lequel chaque dispositif de signalisation (CMᵢ) comprend en outre :
- une micro-unité de commande (31) qui reçoit lesdits signaux en provenance du système central de contrôle / commande de batterie (3) ou lesdits signaux d'état de cellule détectés en provenance desdits capteurs (35, 37, 39) et les transforme en signaux numériques correspondants,
- un premier et un second diviseur de potentiel (41, 47) étant respectivement associé à un premier et à un second comparateur (43, 49),
- et un premier et un second bloc de sortie (45, 51),
(g) dans lequel la micro-unité de commande (31) d'un dispositif de signalisation (CMᵢ) est conçue pour recevoir un signal en provenance d'un dispositif de signalisation adjacent (CMᵢ₋₁ ou CMᵢ₊₁) dans le sens de liaison montante via une connexion filaire (9) par l'intermédiaire du premier diviseur de potentiel (41) et du premier comparateur (43) et dans le sens de liaison descendante via une connexion filaire (9) par l'intermédiaire du second diviseur de potentiel (47) et du second comparateur (49), et est en outre conçue, lorsque cela est nécessaire, pour transmettre via le premier ou le second bloc de sortie (45, 51), respectivement, un signal numérique correspondant au dispositif de signalisation adjacent suivant (CMᵢ₊₁ ou CMᵢ₋₁),
(h) dans lequel chaque bloc de sortie (45, 51) comprend un commutateur électronique (Q₁ⁱ, Q₂ⁱ) ayant une entrée, une sortie et une entrée de commande, la micro-unité de commande (31) étant reliée à l'entrée de commande de sorte que le commutateur électronique (Q₁ⁱ, Q₂ⁱ) est soit rendu passant soit rendu bloquant en fonction du signal numérique en provenance de la micro-unité de commande (31),
(i) dans lequel, dans le sens de liaison montante, le commutateur électronique (Q₁ⁱ) du premier bloc de sortie (45) d'un dispositif de signalisation particulier (CMᵢ) est relié au niveau de sa sortie par ladite connexion filaire (9) au premier diviseur de potentiel (41) au niveau de l'entrée du dispositif de signalisation adjacent de liaison montante (CMᵢ₊₁) et doit être relié au niveau de son entrée à la borne négative (Cᵢ⁻) de la cellule (Cᵢ) associée audit dispositif de signalisation particulier (CMᵢ), tandis que dans le sens de liaison descendante, le commutateur électronique (Q₂ⁱ) du second bloc de sortie (51) dudit dispositif de signalisation particulier (CMᵢ) est relié au niveau de sa sortie par ladite connexion filaire (9) au second diviseur de potentiel (47) au niveau de l'entrée du dispositif de signalisation adjacent de liaison descendante (CMᵢ₋₁) et au niveau de son entrée à ladite troisième tension (V_{cc}ⁱ) produite par le convertisseur continu-continu respectif (57),
(j) dans lequel, dans le sens de liaison montante, ledit dispositif de signalisation particulier (CMᵢ) est conçu pour recevoir des signaux via son premier diviseur de potentiel (41), qui est relié au niveau d'une première extrémité à la connexion filaire (9) à partir du dispositif de signalisation adjacent de liaison descendante (CMᵢ₋₁) et au niveau d'une seconde extrémité à ladite troisième tension (V_{cc}ⁱ) produite par ledit convertisseur continu-continu (57), le premier diviseur de potentiel (41) étant conçu pour délivrer le potentiel divisé à une entrée particulière du premier comparateur (43), qui est muni au niveau de son autre entrée d'une première tension de référence (Vⁱ_{ref1}) choisie pour se situer entre les niveaux de tension qui sont appliqués au niveau de ladite entrée particulière du premier comparateur (43) lorsque le commutateur électronique (Q₁ⁱ⁻¹) du premier bloc de sortie (45) du dispositif de signalisation adjacent de liaison descendante (CMᵢ₋₁) est rendu bloquant ou quand il est rendu passant, de sorte que la sortie du premier comparateur (43) est reliée à une première entrée de la micro-unité de commande (31),
(k) dans lequel, dans le sens de liaison descendante, ledit dispositif de signalisation particulier (CMᵢ) est conçu pour recevoir des signaux via son second diviseur de potentiel (47) qui est relié au niveau d'une première extrémité à la connexion filaire (9) du dispositif de signalisation adjacent de liaison montante (CMᵢ₊₁) et doit être relié au niveau d'une seconde extrémité à la borne négative (Cᵢ⁻) de la cellule (Cᵢ) associée audit dispositif de signalisation particulier (CMᵢ), le second diviseur de potentiel (47) étant conçu pour délivrer le potentiel divisé à une entrée particulière du second comparateur (49), qui est muni au niveau de son autre entrée d'une seconde tension de référence (Vⁱ_{ref2}) choisie pour se situer entre les niveaux de tension qui sont appliqués au niveau de ladite entrée particulière du second comparateur (49) lorsque le commutateur électronique (Q₂ⁱ⁺¹) du second bloc de sortie (51) du dispositif de signalisation adjacent de liaison montante (CMᵢ₊₁) est rendu bloquant ou quand il est rendu passant, de sorte que la sortie du second comparateur (49) est reliée à une seconde entrée de la micro-unité de commande (31),
(l) et dans lequel le système de signalisation est agencé de sorte que des communications entre des dispositifs de signalisation adjacents peuvent se produire dans un sens particulier seulement à un quelconque instant donné en ce que, dans le cas d'une communication de liaison montante, le commutateur électronique (Q₂ⁱ⁺¹) du second bloc de sortie (51) du dispositif de signalisation adjacent de liaison montante (CMᵢ₊₁) est rendu bloquant de sorte qu'il n'affecte pas le fonctionnement du premier diviseur de potentiel (41) du dispositif de signalisation adjacent de liaison montante (CMᵢ₊₁) et dans le cas d'une communication de liaison descendante, le commutateur électronique (Q₁ⁱ⁻¹) du premier bloc de sortie (45) du dispositif de signalisation adjacent de liaison descendante (CMᵢ₋₁) est rendu bloquant de sorte que les messages et les signaux passent par le second diviseur de potentiel (49) et le second comparateur (47) du dispositif de signalisation adjacent de liaison descendante (CMᵢ₋₁) dans la micro-unité de commande (31) du dispositif de signalisation adjacent de liaison descendante (CMᵢ₋₁).

3. Système de signalisation pour une utilisation avec n cellules de batterie reliées en série (Cᵢ) comprenant :
(a) des dispositifs de signalisation (CMᵢ₋₁, CMᵢ, CMᵢ₊₁), chaque dispositif de signalisation étant associé à une ou plusieurs desdites n cellules de batterie (Cᵢ),
(b) chaque dispositif de signalisation (CMᵢ) étant muni de capteurs de contrôle de cellule (35, 37, 39) pour contrôler ou commander l'état de la cellule de batterie associée (Cᵢ) et étant de plus muni d'une liaison de communication à deux fils (9 ; 9a, 9b) avec un système central de contrôle / commande de batterie (3), la liaison de communication (9 ; 9a, 9b) servant à transmettre soit des signaux en provenance du système central de contrôle / commande de batterie (3) soit des signaux d'état de cellule indicatifs des données de capteur,
(c) les dispositifs de signalisation (CMᵢ₋₁, CMᵢ, CMᵢ₊₁) étant électriquement reliés en série de sorte qu'il y ait une liaison de communication filaire (9a) dans un sens de liaison montante à partir du système central de contrôle / commande de batterie (3) via le premier dispositif de signalisation (CM₁) dans la série vers chacun des dispositifs de signalisation suivants à leur tour et une liaison de communication (9b) dans un sens de liaison descendante à partir du dernier dispositif de signalisation (CMₙ) dans la série en retour par l'intermédiaire de chacun des dispositifs de signalisation (CMᵢ₊₁, CMᵢ, CMᵢ₋₁) dans la série jusqu'au système central de contrôle / commande (3),
(d) chaque dispositif de signalisation (CMᵢ) ayant sa propre identification de cellule ou adresse de façon à permettre aux signaux en provenance du système central de contrôle / commande de batterie (3) d'être dirigés vers un dispositif de signalisation spécifique (CMᵢ) et pour permettre au système central de contrôle / commande de batterie (3) d'identifier la source de signaux d'état de cellule reçus en provenance des dispositifs de signalisation (CMᵢ₋₁, CMᵢ, CMᵢ₊₁),
(e) chaque dispositif de signalisation (CMᵢ) comprenant un convertisseur continu-continu (57) dont l'entrée doit être reliée à la borne positive (Cᵢ⁺) et à la borne négative (Cᵢ⁻) de la cellule de batterie respective (Cᵢ) et qui produit une troisième tension (V_{cc}ⁱ) pour alimenter le dispositif de signalisation respectif (CMᵢ),
(f) dans lequel chaque dispositif de signalisation (CMᵢ) comprend en outre :
- une micro-unité de commande (31) qui reçoit lesdits signaux en provenance du système central de contrôle / commande de batterie (3) ou lesdits signaux d'état de cellule détectés en provenance desdits capteurs (35, 37, 39) et les transforme en signaux numériques correspondants,
- un premier et un second diviseur de potentiel (41, 47) étant respectivement associé à un premier et à un second comparateur (43, 49),
- et un premier et un second bloc de sortie (45, 51),
(g) dans lequel la micro-unité de commande (31) d'un dispositif de signalisation (CMᵢ) est conçue pour recevoir un signal en provenance d'un dispositif de signalisation adjacent (CMᵢ₋₁ ou CMᵢ₊₁) dans le sens de liaison montante via une première connexion filaire (9a) par l'intermédiaire du premier diviseur de potentiel (41) et du premier comparateur (43) et dans le sens de liaison descendante via une seconde connexion filaire (9b) par l'intermédiaire du second diviseur de potentiel (47) et du second comparateur (49), et est en outre conçue, lorsque cela est nécessaire, pour transmettre via le premier ou le second bloc de sortie (45, 51), respectivement, un signal numérique correspondant au dispositif de signalisation adjacent suivant (CMᵢ₊₁ ou CMᵢ₋₁),
(h) dans lequel chaque bloc de sortie (45, 51) comprend un commutateur électronique (Q₁ⁱ, Q₂ⁱ) ayant une entrée, une sortie et une entrée de commande, la micro-unité de commande (31) étant reliée à l'entrée de commande de sorte que le commutateur électronique (Q₁ⁱ, Q₂ⁱ) est soit rendu passant soit rendu bloquant en fonction du signal numérique en provenance de la micro-unité de commande (31),
(i) dans lequel, dans le sens de liaison montante, le commutateur électronique (Q₁ⁱ) du premier bloc de sortie (45) d'un dispositif de signalisation particulier (CMᵢ) est relié au niveau de sa sortie par ladite première connexion filaire (9a) au premier diviseur de potentiel (41) au niveau de l'entrée du dispositif de signalisation adjacent de liaison montante (CMᵢ₊₁) et doit être relié au niveau de son entrée à la borne négative (Cᵢ⁻) de la cellule (Cᵢ) associée audit dispositif de signalisation particulier (CMᵢ), tandis que dans le sens de liaison descendante, le commutateur électronique (Q₂ⁱ) du second bloc de sortie (51) dudit dispositif de signalisation particulier (CMᵢ) est relié au niveau de sa sortie par ladite seconde connexion filaire (9b) au second diviseur de potentiel (47) au niveau de l'entrée du dispositif de signalisation adjacent de liaison descendante (CMᵢ₋₁) et au niveau de son entrée à ladite troisième tension (V_{cc}ⁱ) produite par le convertisseur continu-continu respectif (57),
(j) dans lequel, dans le sens de liaison montante, ledit dispositif de signalisation particulier (CMᵢ) est conçu pour recevoir des signaux via son premier diviseur de potentiel (41), qui est relié au niveau d'une première extrémité à la connexion filaire (9a) à partir du dispositif de signalisation adjacent de liaison descendante (CMᵢ₋₁) et au niveau d'une seconde extrémité à ladite troisième tension (V_{cc}ⁱ) produite par ledit convertisseur continu-continu (57), le premier diviseur de potentiel (41) étant conçu pour délivrer le potentiel divisé à une entrée particulière du premier comparateur (43), qui est muni au niveau de son autre entrée d'une première tension de référence (V¹_{ref1}) choisie pour se situer entre les niveaux de tension qui sont appliqués au niveau de ladite entrée particulière du premier comparateur (43) lorsque le commutateur électronique (Q₁ⁱ⁻¹) du premier bloc de sortie (45) du dispositif de signalisation adjacent de liaison descendante (CMᵢ₋₁) est rendu bloquant ou quand il est rendu passant, de sorte que la sortie du premier comparateur (43) est reliée à une première entrée de la micro-unité de commande (31),
(k) et dans lequel, dans le sens de liaison descendante, ledit dispositif de signalisation particulier (CMᵢ) est conçu pour recevoir des signaux via son second diviseur de potentiel (47) qui est relié au niveau d'une première extrémité à la seconde connexion filaire (9b) à partir du dispositif de signalisation adjacent de liaison montante (CMᵢ₊₁) et doit être relié au niveau d'une seconde extrémité à la borne négative (Cᵢ⁻) de la cellule (Cᵢ) associée audit dispositif de signalisation particulier (CMᵢ), le second diviseur de potentiel (47) étant conçu pour délivrer le potentiel divisé à une entrée particulière du second comparateur (49), qui est muni au niveau de son autre entrée d'une seconde tension de référence (Vⁱ_{ref2}) choisie pour se situer entre les niveaux de tension qui sont appliqués au niveau de ladite entrée particulière du second comparateur (49) lorsque le commutateur électronique (Q₂ⁱ⁺¹) du second bloc de sortie (51) du dispositif de signalisation adjacent de liaison montante (CMᵢ₊₁) est rendu bloquant ou quand il est rendu passant, de sorte que la sortie du second comparateur (49) est reliée à une seconde entrée de la micro-unité de commande (31).

4. Système de signalisation selon l'une quelconque des revendications 1 à 3, dans lequel chaque micro-unité de commande est agencée :
(i) pour recevoir des communications en provenance de ladite liaison de communication ;
(ii) pour déterminer si la communication reçue est pour elle-même ou pour une retransmission ; et
(iii) si c'est pour une retransmission, pour resynchroniser la communication reçue et pour sortir la communication resynchronisée pour une retransmission.

5. Batterie comprenant n cellules de batterie reliées en série et un système de signalisation selon l'une quelconque des revendications précédentes.
